# EUROPEAN PATENT APPLICATION

(11) **EP 4 191 336 A1**
(43) Date of publication of application: **07.06.2023**
(21) Application number: 22208119.2
(22) Date of filing: 17.11.2022
(51) Int. Cl.: G03F 7/09, G03F 7/11

(54) **RESIST UNDERLAYER FILM MATERIAL, PATTERNING PROCESS, AND METHOD FOR FORMING RESIST UNDERLAYER FILM**

(30) Priority: 24.11.2021 JP 2021190440
(71) Applicant: SHIN-ETSU CHEMICAL CO., LTD., Tokyo 1000005 (JP)
(72) Inventor: KOBAYASHI, Naoki, Niigata (JP); KORI, Daisuke, Niigata (JP); YAMAMOTO, Yasuyuki, Niigata (JP); SATOH, Hironori, Niigata (JP); YANO, Toshiharu, Niigata (JP)
(74) Representative: Sonnenhauser, Thomas Martin

(57) **Abstract**

A resist underlayer film material contains (A) a resin having a compound shown in the following general formula (1A), and (B) an organic solvent. Mw/Mn of the compound shown in the general formula (1A) is 1.00≤Mw/Mn≤1.25. This provides: a resist underlayer film material having all of favorable dry etching resistance, heat resistance to 500°C or higher, and high filling and planarizing properties; and methods for forming a resist underlayer film and patterning processes which use the material.

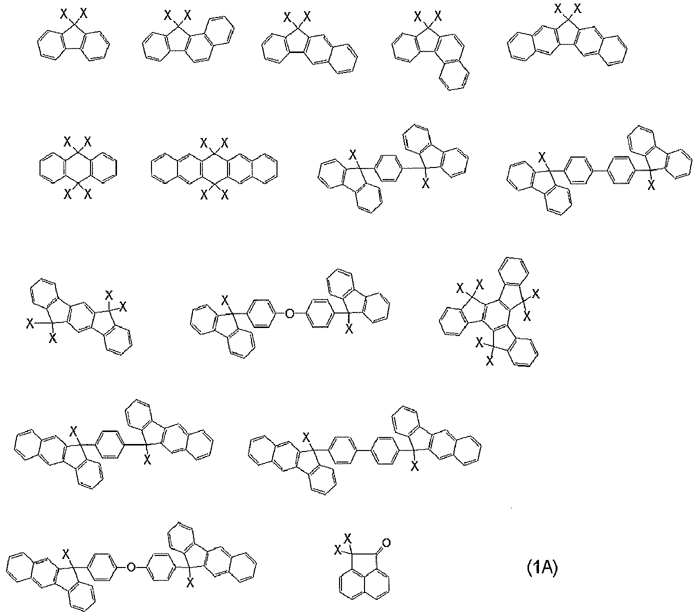

## Description

### TECHNICAL FIELD

The present invention relates to: a resist underlayer film material used for fine patterning by a multilayer resist method in a semiconductor-device manufacturing process; and a patterning process and a method for forming a resist underlayer film which use the material.

### BACKGROUND ART

As LSI advances toward high integration and high processing speed, miniaturization of pattern size is progressing rapidly. Along with this miniaturization, lithography technology has achieved fine patterning by shortening the wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble. Thereby, a pattern is formed by dissolving the exposed part, and the remaining resist pattern is used as an etching mask to process a substrate to be processed by dry etching.

However, when the pattern becomes finer, that is, the pattern width is reduced without changing the thickness of the photoresist film to be used, resolution performance of the photoresist film is lowered. In addition, pattern development of the photoresist film with a developer excessively increases what is called an aspect ratio, resulting in pattern collapse problem. Therefore, photoresist films have been thinned along with the pattern miniaturization.

On the other hand, a substrate to be processed has been generally processed by dry etching using a pattern-formed photoresist film as an etching mask. In practice, however, there is no dry etching method capable of providing an absolute etching selectivity between the photoresist film and the substrate to be processed. Hence, there are problems that the photoresist film is damaged and collapses during processing of the substrate, and that the resist pattern cannot be precisely transferred to the substrate to be processed. Accordingly, resist compositions have been required to have higher dry etching resistance along with the pattern miniaturization. Meanwhile, to enhance the resolution, resins used for photoresist compositions have been required to have low absorbance at the exposure wavelength. Accordingly, as the exposure light shifts to shorter wavelengths from i-beam to KrF and to ArF, the resin shifts to novolak resins, polyhydroxystyrene, and resins having aliphatic polycyclic skeletons. This shift actually accelerates an etching rate under dry etching conditions in processing the substrate, and recent photoresist compositions for high resolution tend to have low etching resistance.

As a result, a substrate to be processed has to be dry etched with a thinner photoresist film having lower etching resistance. A material and procedure reliably employed in this processing are urgently needed.

A multilayer resist method is one solution for these problems. This method is as follows: a resist middle layer film having a different etching selectivity from a photoresist film (i.e., a resist upper layer film) is placed between the resist upper layer film and a substrate to be processed; a pattern is formed in the resist upper layer film; then, the pattern is transferred to the resist middle layer film by dry etching using the resist upper layer film pattern as a dry etching mask; and the pattern is further transferred to the substrate to be processed by dry etching using the resist middle layer film as a dry etching mask.

One of the multilayer resist methods is a three-layer resist method, which can be performed with a typical resist composition used in the monolayer resist method. This three-layer resist method includes, for example, the following steps: an organic film made of a novolak resin or the like is formed as a resist underlayer film on a substrate to be processed; a silicon-containing resist middle layer film is formed as a resist middle layer film on the resist underlayer film; a usual organic photoresist film is formed as a resist upper layer film on the resist middle layer film. Since the organic resist upper layer film exhibits a favorable etching selectivity ratio relative to the silicon-containing resist middle layer film when dry etching is performed with fluorine-based gas plasma, the resist upper layer film pattern can be transferred to the silicon-containing resist middle layer film by employing dry etching with fluorine-based gas plasma. According to this method, even if a resist composition to be used has difficulty in forming a pattern with a sufficient film thickness for directly processing the substrate to be processed or has insufficient dry etching resistance for processing the substrate, the pattern can be transferred to the silicon-containing resist middle layer film (resist middle layer film). Moreover, the subsequent dry etching with oxygen-based or hydrogen-based gas plasma enables the pattern to be transferred into the organic film (resist underlayer film) made of a novolak resin or the like having a sufficient dry etching resistance for processing the substrate. Numerous resist underlayer films as described above have been already known and disclosed in, for example, Patent Document 1, etc.

Meanwhile, in recent years, miniaturization of DRAM memories has accelerated, and there are growing needs for an underlayer film having excellent filling property or planarizing property in addition to dry etching resistance. For example, in a case where a base substrate to be processed has a fine pattern structure with high aspect ratio, filling property is required to fill the pattern with a film without leaving space (void). Moreover, in a case where a fine-pattern dense portion as described above and a pattern-free region exist on the same wafer, it is necessary to planarize the surface by using a resist underlayer film. Planarizing the surface with a resist underlayer film can suppress the film thickness fluctuation of a resist middle layer film and a resist upper layer film formed on the resist underlayer film, and can increase the focus margin in lithography and the margin in a subsequent step of processing the substrate to be processed. Further, as an inorganic-hard-mask middle layer film formed on the resist underlayer film, it is preferable to use a SiON film that is effective as an antireflective coating. Nevertheless, since the SiON film is formed, the substrate temperature reaches 400 to 500°C, so that the resist underlayer film is required to have resistance to high temperature of 500°C or higher. Additionally, since the process becomes complicated, a method is utilized in which several hard masks requiring high-temperature treatment of 400 to 500°C are formed on the resist underlayer film material. Thus, there are needs for a resist underlayer film material having more excellent high-temperature resistance.

As an approach to enhance filling and planarizing properties of a resist underlayer film material, addition of a liquid additive such as polyether polyol has been proposed (Patent Document 2). However, the resist underlayer film formed by this method contains a large amount of polyether polyol units that are inferior in etching resistance. Hence, the etching resistance is greatly lowered, making the resist underlayer film unsuitable.

As a resist underlayer film capable of achieving both filling/planarizing property and etching resistance in high dimension, Patent Documents 3, 4, and 5 propose compounds in which a hydroxyl group is protected with a group containing a triple bond. However, these materials have insufficient adhesiveness to a substrate to be processed. Hence, in the latest generation with further advanced miniaturization, defect such as peeling may occur during the process in a portion where individual fine pattern structures with high aspect ratio are densely formed. Accordingly, there are demands for a material capable of filling and planarizing such a fine-pattern-structure dense portion with high aspect ratio, the material causing no peeling from a substrate.

### CITATION LIST

### PATENT LITERATURE

Patent Document 1: JP 2004-205685 A
Patent Document 2: JP 6550760 B
Patent Document 3: JP 6641879 B
Patent Document 4: JP 6714493 B
Patent Document 5: JP 6462602 B

### SUMMARY OF INVENTION

### TECHNICAL PROBLEM

The present invention has been made in view of the above circumstances. An object of the present invention is to provide: a resist underlayer film material having all of favorable dry etching resistance, heat resistance to 500°C or higher, and high filling and planarizing properties; and a method for forming a resist underlayer film and a patterning process which use the material.

### SOLUTION TO PROBLEM

To achieve the object, the present invention provides a resist underlayer film material used in a multilayer resist method, comprising:
(A) a resin having a compound shown in the following general formula (1A); and
(B) an organic solvent,
   wherein a ratio Mw/Mn of a weight-average molecular weight Mw and a number-average molecular weight Mn of the compound shown in the general formula (1A) in terms of polystyrene by a gel permeation chromatography method is 1.00≤Mw/Mn≤1.25,
   each X in the general formula (1A) represents a group shown by the following general formula (1B),
   R₁ in the general formula (1B) represents any of a hydrogen atom, an organic group having 1 to 10 carbon atoms, and a structure shown in the following general formula (1C), and
   the component (A) as a whole satisfies relations of a+b=1 and 0.2≤b≤0.8, where "a" represents a proportion of the hydrogen atom, and "b" represents a proportion of the organic group having 1 to 10 carbon atoms or structure shown by the general formula (1C) among the structures constituting R₁, 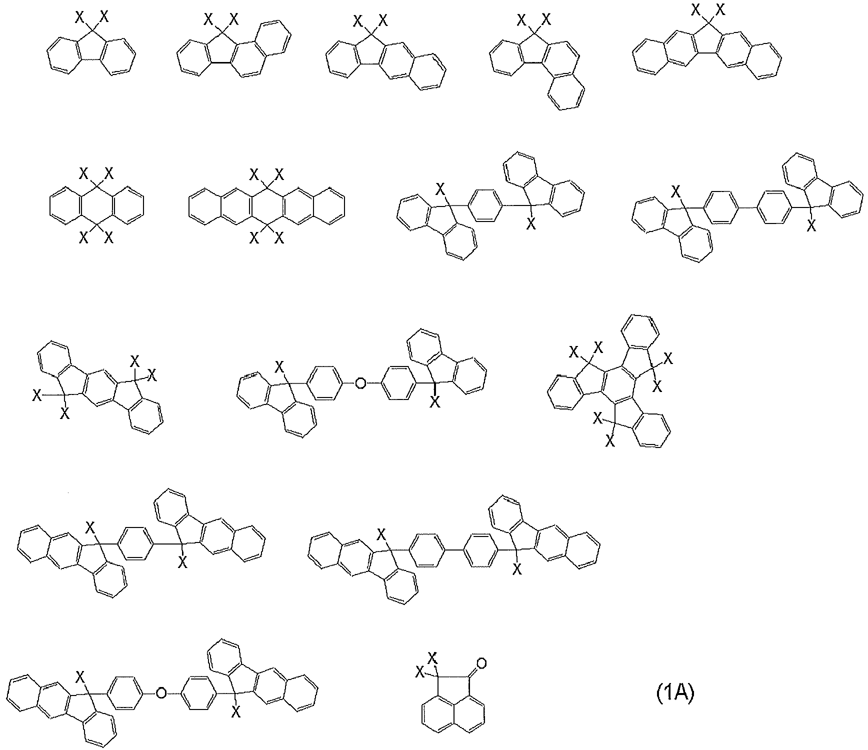 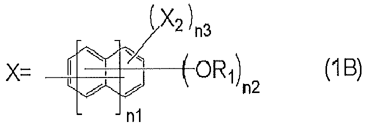 wherein n₁ represents 0 or 1; n₂ represents 1 or 2; R₁ represents any of a hydrogen atom, an organic group having 1 to 10 carbon atoms, and a structure shown in the following general formula (1C); the component (A) as a whole satisfies the relations of a+b=1 and 0.2≤b≤0.8, where "a" represents the proportion of the hydrogen atom, and "b" represents the proportion of the organic group having 1 to 10 carbon atoms or structure shown by the general formula (1C) among the structures constituting R₁; X₂ represents a group shown by the following general formula (1D); and n₃ represents 0, 1, or 2, 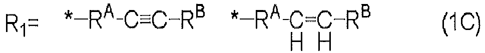 wherein * represents an attachment point to the oxygen atom, R^{A} represents a divalent organic group having 1 to 10 carbon atoms, and R^{B} represents a hydrogen atom or a monovalent organic group having 1 to 10 carbon atoms, 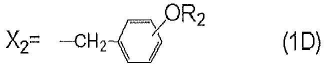 wherein R₂ represents a hydrogen atom or a saturated or unsaturated hydrocarbon group having 1 to 10 carbon atoms, and a hydrogen atom on the benzene ring in the general formula (1D) is optionally substituted with a methyl group or a methoxy group.

Such a resist underlayer film material makes it possible to provide a resist underlayer film material having all of favorable dry etching resistance, heat resistance to 500°C or higher, and high filling and planarizing properties. In addition, controlling the proportion b of the organic structure(s) constituting R₁ in the general formula (1B) within such a range enables all filling property, planarizing property, and peeling resistance at high levels.

Moreover, in the present invention, a constituent component of R₁ in the general formula (1B) preferably comprises a hydrogen atom and any in the following general formula (IF), 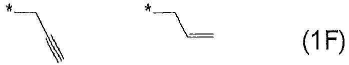 wherein * represents the attachment point to the oxygen atom.

Such a resist underlayer film material is excellent in flowability, thereby making it possible to provide a resist underlayer film material having high filling and planarizing properties.

Further, the compound shown in the general formula (1A) preferably has a weight-average molecular weight of 2,500 or less.

When the weight-average molecular weight of the compound shown in the general formula (1A) is as described above, the resist underlayer film material has further favorable thermal flowability. Thus, blending such a compound in the resist underlayer film material makes it possible to not only favorably fill a fine structure formed on a substrate, but also form a resist underlayer film that makes the substrate entirely flat.

Additionally, in the present invention, the resist underlayer film material preferably further comprises (C) a crosslinking agent.

More preferably, the crosslinking agent (C) is contained in an amount of 5 to 50 parts by mass based on 100 parts by mass of the resin (A).

By incorporating the crosslinking agent (C) in such a range, the curing reaction with the hydroxyl group contained in the resin (A) sufficiently progresses, enabling dense (fine) film formation. Thus, a resist underlayer film excellent in heat resistance to 500°C or higher can be formed.

Moreover, the inventive resist underlayer film material preferably further comprises one or more of (D) a surfactant, (E) an acid generator, (F) a plasticizer, and (G) a pigment.

The inventive resist underlayer film material is practically preferable because fine adjustment of performances, such as coating-film formability by spin coating, curing temperature, filling and planarizing properties, and optical properties (light-absorption property), is possible in accordance with needs and demands by incorporating or not incorporating/selecting additives as described above.

Moreover, in the present invention, the organic solvent (B) preferably comprises a high-boiling-point solvent.

More preferably, in this case, the high-boiling-point solvent comprises one or more organic solvents each having a boiling point of 180°C or higher.

Such a resist underlayer film material has higher flowability and thus further favorable filling and planarizing properties.

In addition, the present invention provides a patterning process for forming a pattern in a substrate to be processed, comprising steps of:
(I-1) applying the above-described resist underlayer film material onto the substrate to be processed, followed by heating to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

Moreover, the present invention provides a patterning process for forming a pattern in a substrate to be processed, comprising steps of:
(II-1) applying the above-described resist underlayer film material onto the substrate to be processed, followed by heating to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed.

Further, the present invention provides a patterning process for forming a pattern in a substrate to be processed, comprising steps of:
(III-1) applying the above-described resist underlayer film material onto the substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

In these ways, the inventive resist underlayer film material can be suitably employed in various patterning processes, such as 2-layer resist process, 3-layer resist process using a resist middle layer film, and 4-layer resist process additionally using an organic thin film. These patterning processes enable effective reductions in unevenness and steps of a substrate to be processed by forming a resist underlayer film, and are suitable for photolithography of resist upper layer films.

Moreover, in the inventive patterning processes, the substrate to be processed may have a structure or step with a height of 30 nm or more.

Because of the use of the inventive resist underlayer film material capable of forming a resist underlayer film having high filling and planarizing properties, the inventive patterning processes are particularly useful for fine processing of a substrate having such a structure or step.

Further, the present invention provides a method for forming a resist underlayer film that serves as an organic planarizing film employed in a semiconductor device manufacturing process, the method comprising:
spin-coating a substrate to be processed with the above-described resist underlayer film material; and
heating the substrate coated with the resist underlayer film material at a temperature of 100°C or higher and 600°C or lower for 10 to 600 seconds to form a cured film.

Furthermore, the present invention provides a method for forming a resist underlayer film that serves as an organic planarizing film employed in a semiconductor device manufacturing process, the method comprising:
spin-coating a substrate to be processed with the above-described resist underlayer film material; and
heating the substrate coated with the resist underlayer film material under an atmosphere with an oxygen concentration of 1% or more and 21% or less to form a cured film.

Such methods make it possible to more considerably suppress mixing with a resist upper layer film by promoting the crosslinking reaction that takes place when the resist underlayer film is formed. Moreover, by appropriately adjusting the heating temperature, time, and oxygen concentration within the above-described ranges, it is possible to obtain a resist underlayer film having suitable filling, planarizing, and curing properties in accordance with use.

Furthermore, the present invention provides a method for forming a resist underlayer film that serves as an organic planarizing film employed in a semiconductor device manufacturing process, the method comprising:
spin-coating a substrate to be processed with the above-described resist underlayer film material; and
heating the substrate coated with the resist underlayer film material under an atmosphere with an oxygen concentration of less than 1% to form a cured film.

According to such a method, even when a substrate to be processed contains a material that is unstable under heating condition in an oxygen atmosphere, the substrate to be processed is not degraded. The method is useful and makes it possible to more considerably suppress mixing with a resist upper layer film by promoting the crosslinking reaction when the resist underlayer film is formed.

In these events, the substrate to be processed may have a structure or step with a height of 30 nm or more.

Because of the use of the inventive resist underlayer film material capable of forming a resist underlayer film having high filling and planarizing properties, the inventive methods for forming a resist underlayer film are particularly suitable for forming a resist underlayer film on a substrate having such a structure or step.

### ADVANTAGEOUS EFFECTS OF INVENTION

As described above, the resist underlayer film material, the patterning processes, and the methods for forming a resist underlayer film according to the present invention are particularly suitably utilized in multilayer resist processes including filling/planarizing a stepped uneven substrate to be processed, and are quite useful in fine patterning for manufacturing a semiconductor device. The present invention makes it possible to form a resist underlayer film excellent in planarizing property and capable of filling, without causing such defects as void and peeling, a substrate to be processed which has a portion that makes filling/planarization difficult, such as a fine-pattern-structure dense portion with high aspect ratio, as typified by DRAM memories which are progressively miniaturized, especially in a fine patterning process employing a multilayer resist method in a semiconductor-device manufacturing process.

Compounds containing a triple bond are known as means for enhancing filling and planarizing properties from the reports of the prior art JP 6641879 B and JP 6714493 B. However, since these materials have insufficient adhesiveness to a substrate to be processed, defect such as peeling might occur during the process at a fine-pattern-structure dense portion with high aspect ratio in the latest generation with advanced miniaturization. In the fine-pattern-structure dense portion with high aspect ratio, the contact area between the resist underlayer film and the substrate is large, so that the resist underlayer film has to have favorable adhesiveness to the substrate. Further, since recent device-manufacturing processes are complicated, a method is utilized in which several hard masks requiring high-temperature treatment of 400 to 500°C are formed on the resist underlayer film material. For this reason, a resist underlayer film material having more excellent high-temperature resistance is demanded. In contrast, the inventive resist underlayer film material employs a resin having a compound shown in (1A) in such a manner as to control a ratio between an organic group, such as an allyl group or a propargyl group, contributing to enhancement of flowability, and a hydroxyl group contributing to enhancements of substrate adhesiveness and heat resistance. This makes it possible to provide a material having all of filling property, planarizing property, substrate adhesiveness, and heat resistance at high levels.

### BRIEF DESCRIPTION OF DRAWINGS

FIG. 1 is an explanatory diagram illustrating an example (3-layer resist process) of the inventive patterning processes.
FIG. 2 is an explanatory diagram illustrating a method for evaluating filling property.
FIG. 3 is an explanatory diagram illustrating a method for evaluating planarizing property.

### DESCRIPTION OF EMBODIMENTS

As noted above, in a fine patterning process employing a multilayer resist method in a semiconductor-device manufacturing process, there have been demands for a resist underlayer film material which has heat resistance to 500°C or higher enabling hard mask formation requiring high-temperature treatment on the resist underlayer film, and which is capable of filling/planarizing, without causing such defects as void and peeling, a substrate to be processed with a portion that makes filling/planarization difficult, such as a fine-pattern-structure dense portion with high aspect ratio, as typified by DRAM memories being progressively miniaturized.

The present inventors have earnestly studied the above problems and consequently searched various resist underlayer film materials and patterning processes in order to achieve all of high filling, high planarization and excellent heat resistance through resist underlayer film formation in a multilayer resist method using a resist underlayer film. As a result, the inventors have found a resist underlayer film material containing a compound having a particular structure and an optimum ratio between hydroxyl groups and organic crosslinking groups, and found that this resist underlayer film material and patterning processes using the material are very effective. This finding has led to the completion of the present invention.

Specifically, the present invention is a resist underlayer film material used in a multilayer resist method, the material comprising:
(A) a resin having a compound shown in the following general formula (1A); and
(B) an organic solvent,
   wherein a ratio Mw/Mn of a weight-average molecular weight Mw and a number-average molecular weight Mn of the compound shown in the general formula (1A) in terms of polystyrene by a gel permeation chromatography method is 1.00≤Mw/Mn≤1.25,
   each X in the general formula (1A) represents a group shown by the following general formula (1B),
   R₁ in the general formula (1B) represents any of a hydrogen atom, an organic group having 1 to 10 carbon atoms, and a structure shown in the following general formula (1C), and
   the component (A) as a whole satisfies relations of a+b=1 and 0.2≤b≤0.8, where "a" represents a proportion of the hydrogen atom, and "b" represents a proportion of the organic group having 1 to 10 carbon atoms or structure shown by the general formula (1C) among the structures constituting R₁, 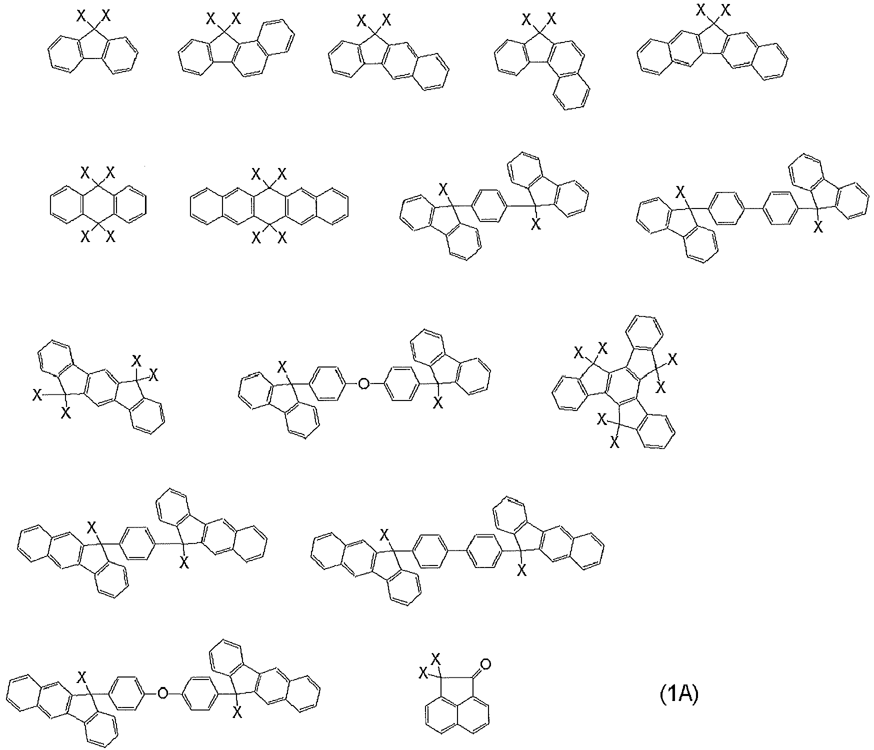 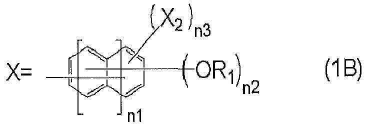 wherein n₁ represents 0 or 1; n₂ represents 1 or 2; R₁ represents any of a hydrogen atom, an organic group having 1 to 10 carbon atoms, and a structure shown in the following general formula (1C); the component (A) as a whole satisfies the relations of a+b=1 and 0.2≤b≤0.8, where "a" represents the proportion of the hydrogen atom, and "b" represents the proportion of the organic group having 1 to 10 carbon atoms or structure shown by the general formula (1C) among the structures constituting R₁; X₂ represents a group shown by the following general formula (1D); and n₃ represents 0, 1, or 2, 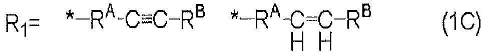 wherein * represents an attachment point to the oxygen atom, R^{A} represents a divalent organic group having 1 to 10 carbon atoms, and R^{B} represents a hydrogen atom or a monovalent organic group having 1 to 10 carbon atoms, 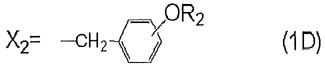 wherein R₂ represents a hydrogen atom or a saturated or unsaturated hydrocarbon group having 1 to 10 carbon atoms, and a hydrogen atom on the benzene ring in the general formula (1D) is optionally substituted with a methyl group or a methoxy group.

Hereinafter, the present invention will be described in detail, but the present invention is not limited thereto.

### <Resist Underlayer Film Material>

The inventive resist underlayer film material is a resist underlayer film material used in a multilayer resist method, and contains: (A) a resin having a compound shown in the following general formula (1A); and (B) an organic solvent. The ratio Mw/Mn of the weight-average molecular weight Mw and the number-average molecular weight Mn of the compound shown in the general formula (1A) in terms of polystyrene determined by a gel permeation chromatography method is 1.00≤Mw/Mn≤1.25. In the general formula (1A), each X represents a group shown by the following general formula (1B). In the general formula (1B), R₁ represents any of a hydrogen atom, an organic group having 1 to 10 carbon atoms, and a structure shown in the following general formula (1C). The component (A) as a whole satisfies relations of a+b=1 and 0.2≤b≤0.8, where "a" represents a proportion of the hydrogen atom, and "b" represents a proportion of the organic group having 1 to 10 carbon atoms or structure shown by the general formula (1C) among the structures constituting R₁. 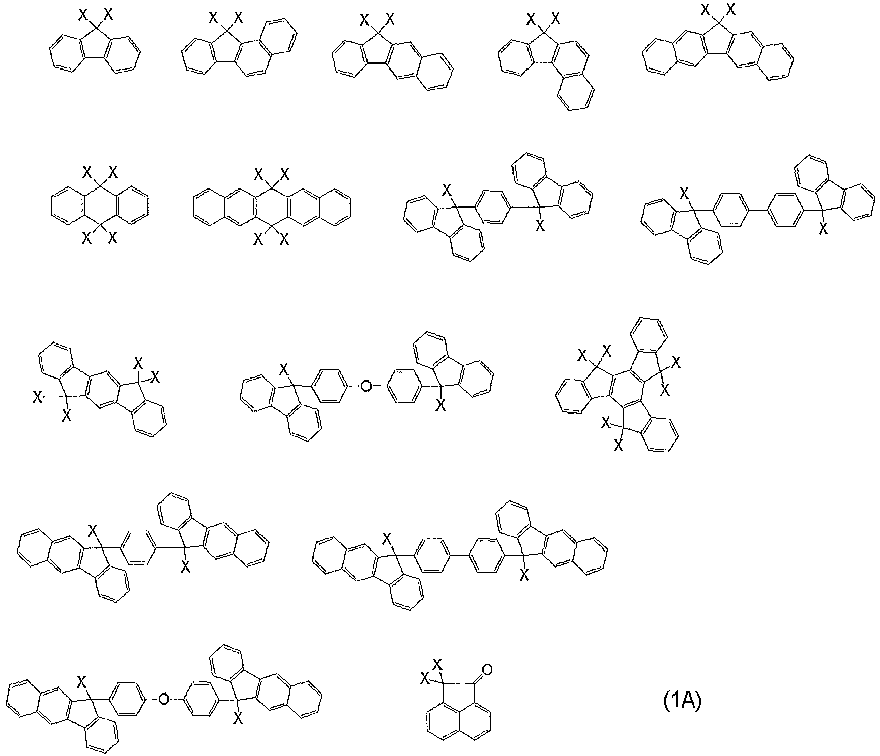 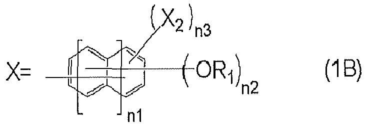 In the general formula (1B), n₁ represents 0 or 1. n₂ represents 1 or 2. R₁ represents any of a hydrogen atom, an organic group having 1 to 10 carbon atoms, and a structure shown in the following general formula (1C). The component (A) as a whole satisfies relations of a+b=1 and 0.2≤b≤0.8, where "a" represents a proportion of the hydrogen atom and "b" represents that of the organic group having 1 to 10 carbon atoms or structure shown by the general formula (1C), among the structures constituting R₁. X₂ represents a group shown by the following general formula (1D). n₃ represents 0, 1, or 2. 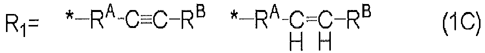 In the general formula (1C), * represents an attachment point to the oxygen atom. R^{A} represents a divalent organic group having 1 to 10 carbon atoms. R^{B} represents a hydrogen atom or a monovalent organic group having 1 to 10 carbon atoms. 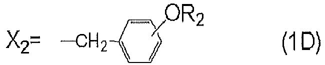 In the general formula (1D), R₂ represents a hydrogen atom or a saturated or unsaturated hydrocarbon group having 1 to 10 carbon atoms. A hydrogen atom on the benzene ring in the general formula (1D) is optionally substituted with a methyl group or a methoxy group.

### [(A) Resin having Compound shown by General Formula (1A)]

Incorporating the resin (A) having a compound shown in the following general formula (1A) enables the inventive resist underlayer film material to: fill, without causing defect such as voids or peeling, a substrate to be processed which has a portion that makes filling/planarization difficult, such as a fine-pattern-structure dense portion with high aspect ratio; and form a resist underlayer film excellent in planarizing property. 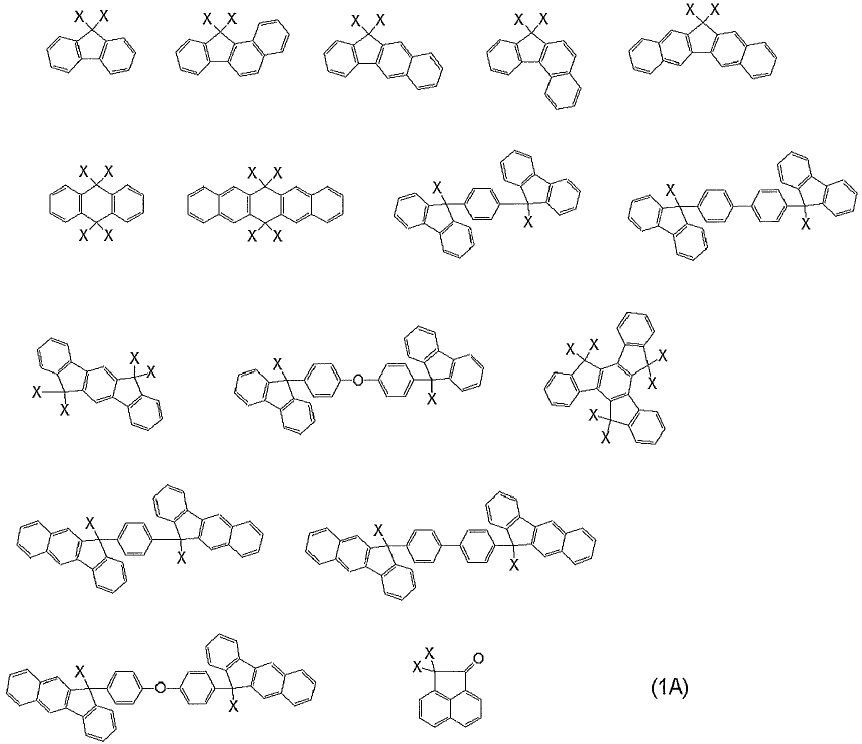 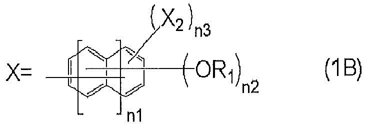 In the general formula (1B), n₁ represents 0 or 1. n₂ represents 1 or 2. R₁ represents any of a hydrogen atom, an organic group having 1 to 10 carbon atoms, and a structure shown in the following general formula (1C). The component (A) as a whole satisfies relations of a+b=1 and 0.2≤b≤0.8, where "a" represents a proportion of the hydrogen atom and "b" represents that of the organic group having 1 to 10 carbon atoms or structure shown by the general formula (1C), among the structures constituting R₁. X₂ represents a group shown by the following general formula (1D). n₃ represents 0, 1, or 2. 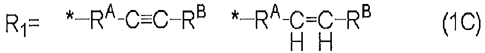 In the general formula (1C), * represents an attachment point to the oxygen atom. R^{A} represents a divalent organic group having 1 to 10 carbon atoms. R^{B} represents a hydrogen atom or a monovalent organic group having 1 to 10 carbon atoms. 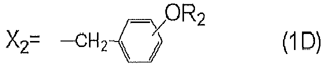 In the general formula (1D), R₂ represents a hydrogen atom or a saturated or unsaturated hydrocarbon group having 1 to 10 carbon atoms. A hydrogen atom on the benzene ring in the general formula (1D) is optionally substituted with a methyl group or a methoxy group.

In the general formula (1B), n₁ is preferably 1, and n₂ is preferably 1. Moreover, each R₁ can be any of a hydrogen atom, an alkyl group having 1 to 10 carbon atoms, and a structure shown in the general formula (1C), and the compound shown in the general formula (1A) preferably contains both a hydrogen atom and a structure shown in the general formula (1C) as R₁'s.

Having such a structure with many aromatic rings as described above enables formation of a resist underlayer film excellent in heat resistance and dry etching resistance. Further having both of a hydroxyl group that is a hydrophilic group and a structure of the general formula (1C) that is a hydrophobic group makes it possible to provide a resist underlayer film material having both of excellent thermal flowability and substrate adhesiveness.

Examples of the divalent organic group having 1 to 10 carbon atoms represented by R^{A} in the general formula (1C) include alkanediyl groups, such as a methylene group, an ethanediyl group, a propanediyl group, a butanediyl group, a pentanediyl group, a hexanediyl group, an octanediyl group, and a decanediyl group; arenediyl groups, such as a benzenediyl group, a methylbenzenediyl group, and a naphthalenediyl group; etc.

Examples of the monovalent organic group having 1 to 10 carbon atoms represented by R^{B} in the general formula (1C) include alkyl groups, such as a methyl group, an ethyl group, an n-propyl group, an i-propyl group, an n-butyl group, an i-butyl group, a sec-butyl group, a t-butyl group, an n-pentyl group, an n-hexyl group, an n-octyl group, and an n-decyl group; aryl groups, such as a phenyl group, a tolyl group, a xylyl group, a mesityl group, and a naphthyl group; etc.

These alkanediyl groups, arenediyl groups, alkyl groups, aryl groups, and the like may have some or all of hydrogen atoms substituted. Examples of such substituents include alkoxy groups, such as a methoxy group, an ethoxy group, an n-propoxy group, an i-propoxy group, an n-butoxy group, an i-butoxy group, a secbutoxy group, a t-butoxy group, an n-pentyloxy group, and an n-hexyloxy group; alkoxycarbonyl groups, such as a methoxycarbonyl group, an ethoxycarbonyl group, an n-propoxycarbonyl group, an i-propoxycarbonyl group, an n-butoxycarbonyl group, an i-butoxycarbonyl group, a secbutoxycarbonyl group, a t-butoxycarbonyl group, an n-pentyloxycarbonyl group, and an n-hexyloxycarbonyl group; etc.

Particularly preferable examples of the constituent component of R₁ in the general formula (1B) can include a hydrogen atom and structures constituted of any in the following general formula (IF). Having such structures makes the thermal flowability favorable, and can provide the resist underlayer film material excellent in filling and planarizing properties. Moreover, the heat resistance and film formability become favorable, sublimation products are suppressed during heat curing, contamination of the apparatus due to the sublimation products is suppressed, and coating defect can be suppressed. 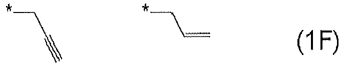 In the general formula (IF), * represents an attachment point to an oxygen atom.

The component (A) as a whole satisfies relations of a+b=1 and 0.2≤b≤0.8, and preferably a relation of 0.3≤b≤0.7, more preferably a relation of 0.4≤b≤0.6, where "a" represents the proportion of hydrogen atoms, and "b" represents the proportion of organic groups having 1 to 10 carbon atoms or structures shown by the general formula (1C).

Here, the phrase "the component (A) as a whole satisfies the relations of a+b=1 and 0.2≤b≤0.8" means that: in a case where one kind of the compound shown in the general formula (1A) is used singly, the relations are satisfied by this single kind; or in a case where two or more kinds of the compound shown in the general formula (1A) are used, each kind of the compound satisfies the relations or the relations are satisfied by all the compounds employed.

Controlling the proportions of the hydrogen atoms and the organic groups having 1 to 10 carbon atoms or structures shown by the general formula (1C) within the ranges as described above makes it possible to exhibit high levels of the flowability and the substrate adhesiveness, and to provide a resist underlayer film material with higher filling and planarizing properties. If the range of "b" is b>0.8, the hydroxyl group content is insufficient, so that the adhesiveness to the substrate might be degraded. Moreover, to form a dense film, the hydroxyl groups preferably undergo crosslinking reaction with one another, and it is necessary to incorporate hydroxyl groups in a certain proportion or more from the viewpoint of heat resistance. Meanwhile, if the range of "b" is b<0.2, the resin has insufficient thermal flowability, so that the filling and planarizing properties might be degraded.

Examples of R₂ in the general formula (1D) can include linear or branched alkyl groups, such as a methyl group, an ethyl group, and an isopropyl group; alicyclic hydrocarbon groups, such as a cyclopentyl group, a cyclohexyl group, and a norbornyl group; linear or branched alkenyl groups, such as a vinyl group and a propenyl group; linear or branched alkynyl groups, such as an ethynyl group and a propargyl group; aryl groups, such as a phenyl group and a tolyl group; etc.

Examples of particularly preferable structures of the compound shown in the general formula (1A) include the following. Among these, compounds having two cardo structures are more preferable. 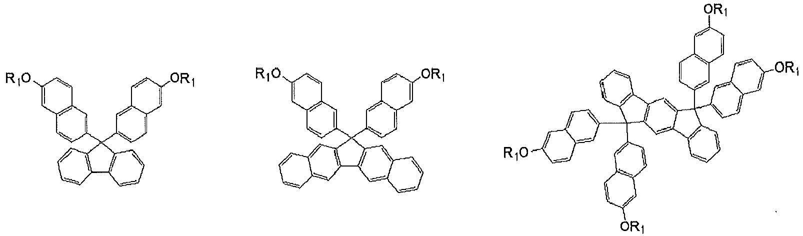 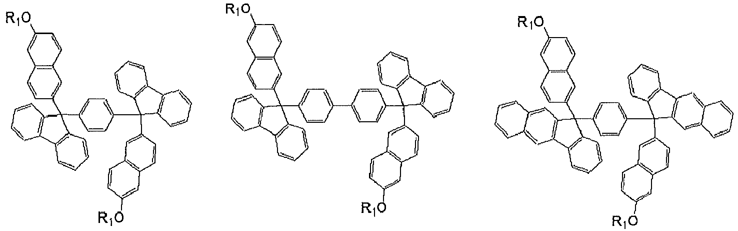 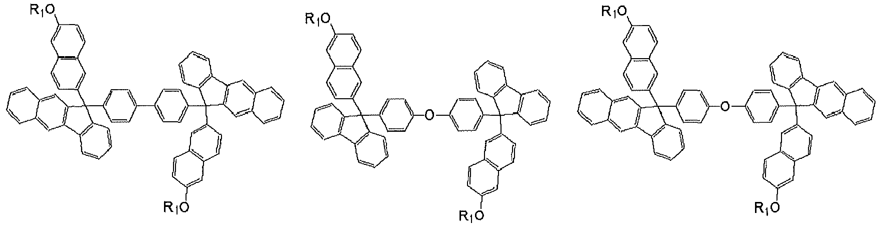 In the formulae, R₁ is as defined above.

The resist underlayer film material containing such a component (A) has a rigid structure incorporating many aromatic rings. This enables formation of a resist underlayer film material having higher heat resistance and favorable etching resistance. Further, the cardo structures introduced in the molecule act not only to relieve the intermolecular interaction and impart the solubility into an organic solvent, but also to enhance the film formability when a coating film is formed, and achieve all of heat resistance, filling property, and planarizing property, which are conflicting properties, even though condensed carbon rings with high carbon density are introduced.

Moreover, the weight-average molecular weight Mw and the number-average molecular weight Mn of the compound shown by the general formula (1A) determined in terms of polystyrene by a gel permeation chromatography method satisfy a ratio Mw/Mn (i.e., dispersity) of 1.00≤Mw/Mn≤1.25. If the dispersity is outside this range, the resist underlayer film material has such low thermal flowability that when the compound is blended in the resist underlayer film material, it is impossible not only to fill a fine structure formed on a substrate, but also to form a resist underlayer film that makes the substrate entirely flat. By definition, the Mw/Mn of monomer compounds is 1.00, but the measurement values exceed 1.00 in some cases due to separability in GPC. Unless a special polymerization method is employed, polymers having repeating units are generally quite difficult to have Mw/Mn close to 1.00, and the Mw distribution of the polymers is such that the Mw/Mn value exceeds 1. In the present invention, 1.00≤Mw/Mn≤1.25 is defined as an indicator indicating monomeric nature to distinguish between monomer compounds and polymers.

Additionally, the weight-average molecular weight of the compound shown in the general formula (1A) is preferably 2,500 or less. With such a molecular weight, the resist underlayer film material has further favorable thermal flowability. Thus, blending such a compound in the resist underlayer film material makes it possible to not only favorably fill a fine structure formed on a substrate, but also form a resist underlayer film that makes the substrate entirely flat.

In the present invention, one kind of the resin having a compound shown in the general formula (1A) may be used singly. Alternatively, a resin having equivalent compounds can be prepared by mixing two or more kinds of compounds shown in the following general formulae (1A') and (1A") in desired proportions. 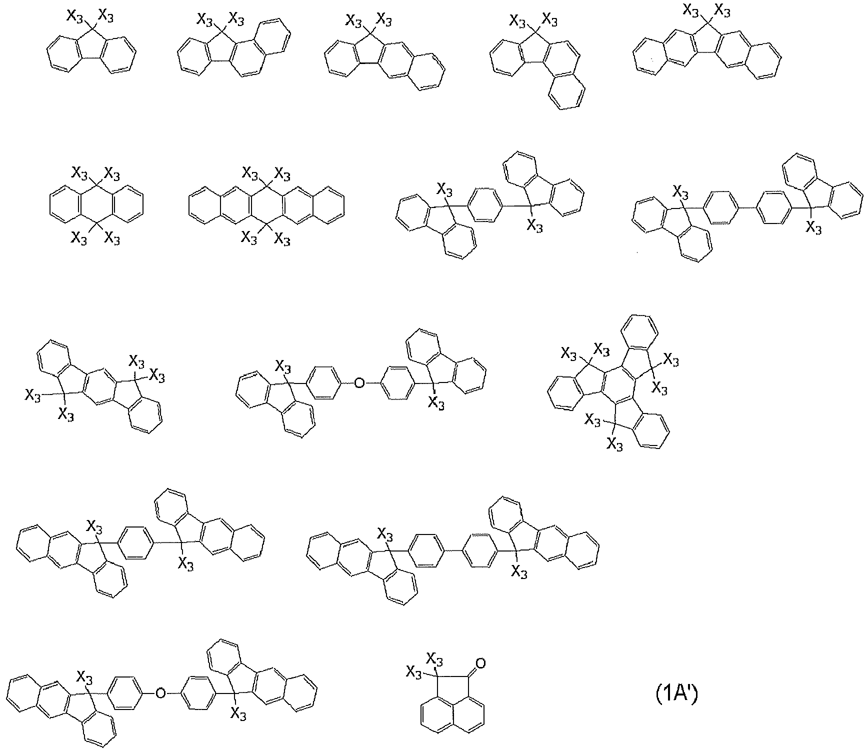 In the general formula (1A'), X₃ represents a group shown by the following general formula (3B). 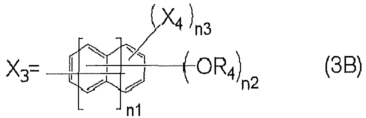 In the general formula (3B), n₁ represents 0 or 1. n₂ represents 1 or 2. R₄ represents a hydrogen atom. X₄ represents a group shown by the general formula (1D). n₃ represents 0, 1, or 2. 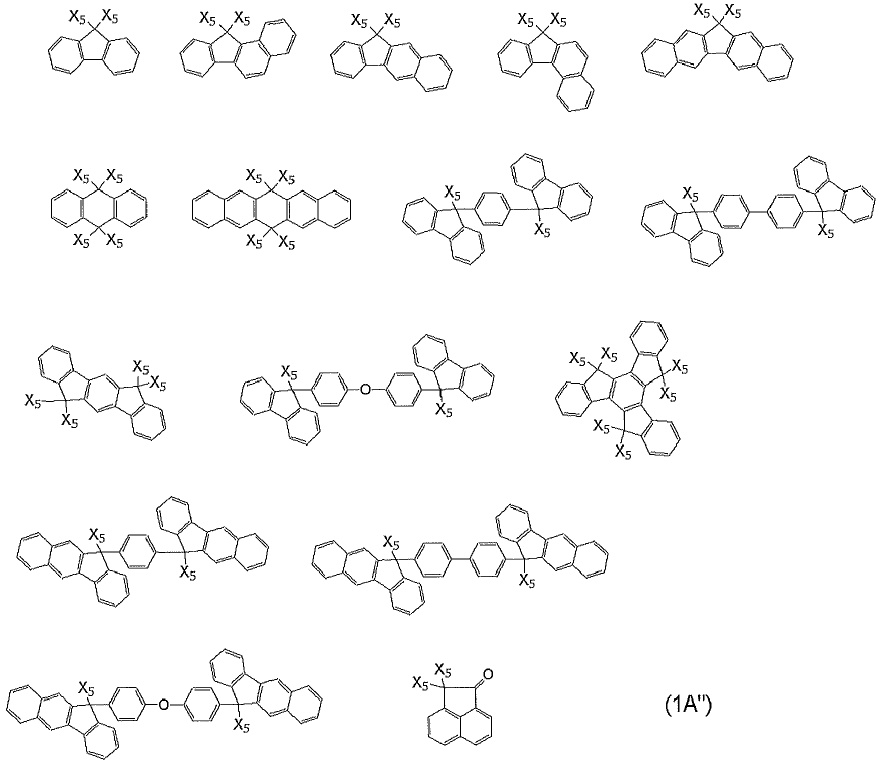 In the general formula (1A"), X₅ represents a group shown by the following general formula (4B). 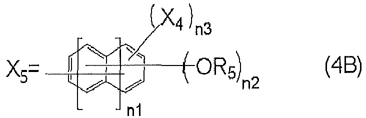 In the general formula (4B), n₁ represents 0 or 1. n₂ represents 1 or 2. R₅ represents either an organic group having 1 to 10 carbon atoms or a structure shown in the general formula (1C). X₄ represents a group shown by the general formula (1D). n₃ represents 0, 1, or 2.

The mixing proportions in the resin having compounds shown in the general formulae (1A') and (1A") preferably satisfy relations of c+d=1 and 0.2≤d≤0.8, and more preferably a relation of 0.3≤d≤0.7, further preferably a relation of 0.4≤d≤0.6, where "c" represents a proportion of R₄ in the structure shown by the general formula (3B), and "d" represents that of R₅ in the structure shown by the general formula (4B).

Controlling the mixing proportions in the resin having compounds shown in the general formulae (1A') and (1A") within the ranges as above makes it possible to exhibit the flowability and substrate adhesiveness at high levels, and to provide a resist underlayer film material having higher filling and planarizing properties. When the range of "d" is d≤0.8, the hydroxyl group content is sufficient, and the adhesiveness to the substrate would not be degraded. Moreover, to form a dense film, the hydroxyl groups preferably undergo crosslinking reaction with one another, and it is preferable to incorporate hydroxyl groups in a certain proportion or more from the viewpoint of heat resistance. Meanwhile, when the range of "d" is d≤0.2, the resin has sufficient thermal flowability, and the filling and planarizing properties would not be degraded.

In the case of using two or more kinds of compounds shown in the general formulae (1A') and (1A") mixed in desired proportions, the ratio Mw/Mn (i.e., dispersity) of the weight-average molecular weight Mw and the number-average molecular weight Mn which are determined in terms of polystyrene by a gel permeation chromatography method is preferably such that each compound satisfies the range of 1.00≤Mw/Mn≤1.25.

In the present invention, a resin containing no compound shown in the general formula (1A) may be mixed and used. The resin that may be mixed together in this case is not particularly limited, and known resins can be used. Specifically, the resin is preferably an acrylic resin, a styrene resin, a phenol resin, a polyether resin, or an epoxy resin.

The inventive resist underlayer film material may be further blended with a different compound or polymer. The blend compound or blend polymer mixed with the resin having a compound shown in the general formula (1A) serves to improve the film formability by spin-coating and/or the filling and planarizing properties for a stepped substrate. The blend compound or blend polymer is preferably a compound having a phenolic hydroxyl group.

Examples of such materials include novolak resins of phenol, o-cresol, m-cresol, p-cresol, 2,3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6,6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, and 7-methoxy-2-naphthol, dihydroxynaphthalenes such as 1,5-dihydroxynaphthalene, 1,7-dihydroxynaphthalene, and 2,6-dihydroxynaphthalene, methyl 3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, limonene, etc.; and polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. It is also possible to blend a naphthol dicyclopentadiene copolymer disclosed in JP 2004-205685 A, a fluorene bisphenol novolak resin disclosed in JP 2005-128509 A, an acenaphthylene copolymer disclosed in JP 2005-250434 A, fullerene having a phenol group disclosed in JP 2006-227391 A, a bisphenol compound and a novolak resin thereof disclosed in JP 2006-293298 A, a novolak resin of an adamantane phenol compound disclosed in JP 2006-285095 A, a bisnaphthol compound and a novolak resin thereof disclosed in JP 2010-122656 A, a fullerene resin compound disclosed in JP 2008-158002 A, etc.

The blendable compound or blendable polymer is blended in an amount of preferably 5 to 100 parts by mass, more preferably 5 to 50 parts by mass, based on 100 parts by mass of the resin having a compound shown by the general formula (1A).

### [(B) Organic Solvent]

The organic solvent (B) usable in the inventive resist underlayer film material is not particularly limited, as long as it is capable of dissolving the resin (A) having a compound shown in the general formula (1A). Preferably, the organic solvent (B) is capable of dissolving (C) a crosslinking agent, (D) a surfactant, (E) an acid generator, (F) a plasticizer, and (G) a pigment, which are described later.

Specifically, organic solvents disclosed in paragraphs [0091] to [0092] of JP 2007-199653 A can be added. More specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, and γ-butyrolactone, or a mixture containing one or more of these.

It is desirable to adjust the amount of the organic solvent blended, depending on an intended thickness of the resist underlayer film. Generally, the amount is in a range of 100 to 50,000 parts by mass based on 100 parts by mass of the resin having a compound shown in the general formula (1A).

Moreover, the organic solvent (B) preferably includes a high-boiling-point solvent. In other words, in the inventive resist underlayer film material, the organic solvent (B) to be used may be a mixture of: one or more organic solvents each having a boiling point of lower than 180°C; and one or more organic solvents each having a boiling point of 180°C or higher (high-boiling-point solvent(s)).

Specific examples of the organic solvents having a boiling point of lower than 180°C can include propylene glycol monomethyl ether acetate, propylene glycol monomethyl ether, propylene glycol monoethyl ether, propylene glycol monopropyl ether, 2-heptanone, cyclopentanone, and cyclohexanone.

The high-boiling-point solvents are not particularly limited to hydrocarbons, alcohols, ketones, esters, ethers, chlorinated solvents, and so forth, as long as the high-boiling-point solvents are capable of dissolving each component of the inventive resist underlayer film material. Specific examples thereof can include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butylmethyl ether, triethylene glycol dimethyl ether, triethylene glycol monomethyl ether, triethylene glycol-n-butyl ether, triethylene glycol butylmethyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, etc. These may be used singly or in mixture thereof.

The high-boiling-point solvent(s) may be appropriately selected, for example, from the above list according to the temperature at which the inventive resist underlayer film material is heated, etc. The boiling point of the high-boiling-point solvent(s) is preferably 180°C to 300°C, further preferably 200°C to 300°C. Such boiling points presumably prevent the evaporation rate at baking (heating) from becoming too fast; thus, the boiling points can provide sufficient thermal flowability during the film formation, and a resist underlayer film excellent in filling property and planarizing property can be formed. Moreover, with such boiling points, the high-boiling-point solvent(s) evaporate after baking and do not remain in the film; thus, the boiling points do not adversely affect the film physical properties, such as etching resistance.

Moreover, when the high-boiling-point solvent(s) are used, the organic solvent(s) are blended in an amount of preferably 1 to 30 parts by mass based on 100 parts by mass of the organic solvent(s) having a boiling point of lower than 180°C. Such a formulation amount can impart sufficient thermal flowability during baking, and prevents degradation of the film physical properties such as etching resistance, which would otherwise occur if the solvent(s) remain in the film. Thus, such a formulation amount is preferable.

### [(C) Crosslinking Agent]

Moreover, the inventive resist underlayer film material can also contain a crosslinking agent (C) so as to increase the curability and to further suppress intermixing with a resist upper layer film. The crosslinking agent is not particularly limited, and known various types of crosslinking agents can be widely used. Examples thereof can include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g., methylolated- or alkoxymethylated polynuclear phenol-based crosslinking agents). The crosslinking agent is contained in an amount of preferably 5 to 50 parts by mass, more preferably 10 to 40 parts by mass, based on 100 parts by mass of the resin (A).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy-and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

A specific example of the β-hydroxyalkylamide-based crosslinking agents includes N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylenebis-4,5-diphenyl-2-oxazoline, 2,2'-methylenebis-4-phenyl-2-oxazoline, 2,2'-methylenebis-4-tert-butyl-2-oxazoline, 2,2'-bis(2-oxazoline), 1,3-phenylenebis(2-oxazoline), 1,4-phenylenebis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include a compound shown by the following general formula (2); 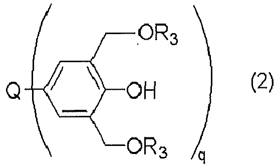 where Q represents a single bond, or a hydrocarbon group with a valency of "q" having 1 to 20 carbon atoms. R₃ represents a hydrogen atom or a methyl group. "q" represents an integer of 1 to 5.

In the general formula (2), Q is a single bond, or a hydrocarbon group having a valency of "q" and 1 to 20 carbon atoms. "q" is an integer of 1 to 5, more preferably 2 or 3. In the case where Q is a hydrocarbon group having a valency of "q" and 1 to 20 carbon atoms, Q is a hydrocarbon group with a valency of "q" corresponding to a hydrocarbon having 1 to 20 carbon atoms from which "q" hydrogen atoms are excluded. In this case, specific examples of the hydrocarbon having 1 to 20 carbon atoms include methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane.

In the general formula (2), R₃ is a hydrogen atom or a methyl group, preferably a methyl group.

Having the compound shown by the general formula (2) as a crosslinking agent increases the crosslinking reactivity of the hydroxyl groups incorporated in the compound shown in the general formula (1A), making it possible to enhance the film denseness. The compound can further enhance the heat resistance of the inventive resist underlayer film material.

Specific examples of the compound shown by the general formula (2) include the following compounds, but are not limited thereto. In the following formulae, R₃ is as defined above. It is preferable to satisfy that "q" is 3 and R₃ is a methyl group from the viewpoints of enhancing the curability and film thickness uniformity, and reducing sublimation products. Particularly, triphenolmethane, triphenolethane, 1,1,1-tris(4-hydroxyphenyl)ethane, and tris(4-hydroxyphenyl)-1-ethyl-4-isopropylbenzene that are subjected to hexamethoxymethylation are preferable.

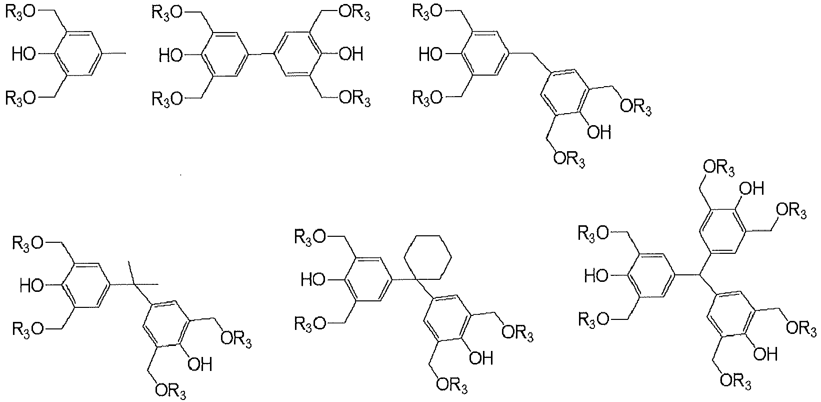

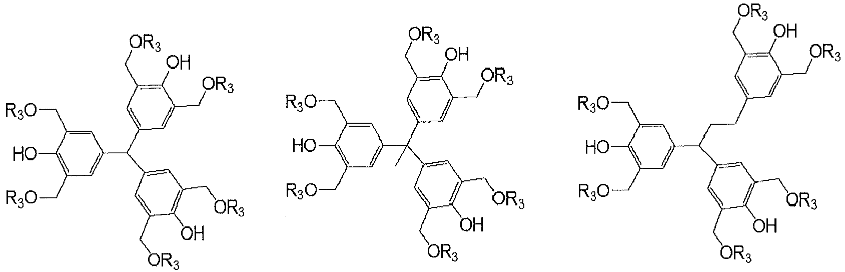

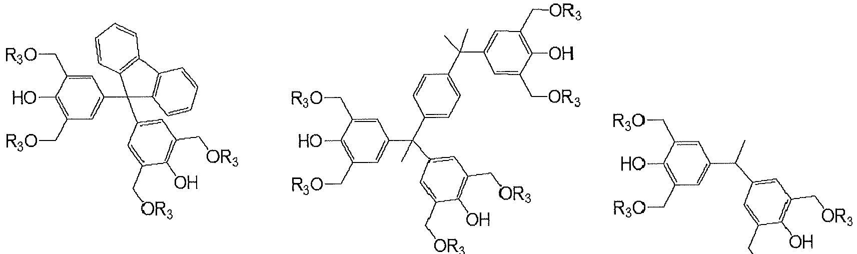

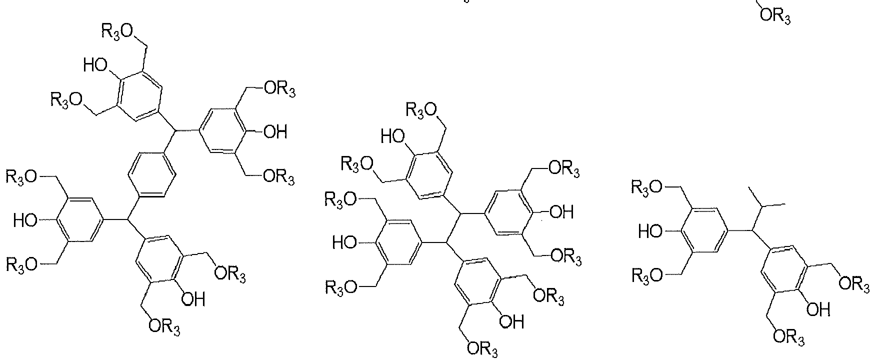

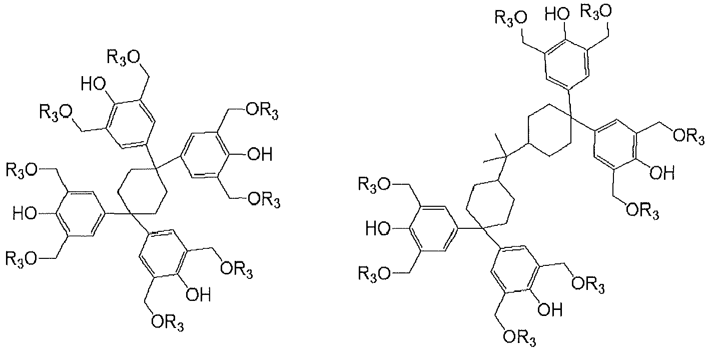

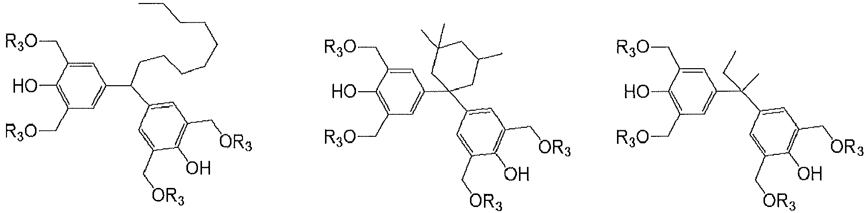

One kind of the crosslinking agent (C) can be used singly, or two or more kinds thereof can be used in combination. The crosslinking agent (C) is contained in an amount of preferably 5 to 50 parts by mass, more preferably 10 to 40 parts by mass, based on 100 parts by mass of the resin (A). When the content is 5 parts by mass or more, the crosslinking reaction with the resin (A) is promoted, and a dense film excellent in curability is formed, so that the resulting resist underlayer film can have favorable heat resistance, dry etching resistance, and film thickness uniformity. Meanwhile, when the content is 50 parts by mass or less, it is possible to suppress generation of sublimation products due to slowed crosslinking reaction involving the resin (A) and the crosslinking agent (C), and to reduce sublimation products and film thickness uniformity degradation.

### [(D) Surfactant]

The inventive resist underlayer film material can contain (D) a surfactant so as to enhance the coating property in spin coating. As the surfactant (D), for example, those disclosed in [0142] to [0147] of JP 2009-269953 A can be used. When contained, the surfactant (D) is contained in an amount of preferably 0.001 to 20 parts by mass, more preferably 0.01 to 10 parts by mass, based on 100 parts by mass of the resin having a compound shown in the general formula (1A).

### [(E) Acid Generator]

The inventive resist underlayer film material can contain (E) an acid generator so as to further promote the curing reaction. The acid generator (E) includes a material that generates an acid by thermal decomposition, and a material that generates an acid by light irradiation. Any of these can be incorporated. Specifically, materials disclosed in paragraphs [0061] to [0085] of JP 2007-199653 A can be added, but the present invention is not limited thereto.

One kind of the acid generator (E) can be used singly, or two or more kinds thereof can be used in combination. When contained, the acid generator (E) is contained in an amount of preferably 0.05 to 50 parts by mass, more preferably 0.1 to 10 parts by mass, based on 100 parts by mass of the resin having a compound shown in the general formula (1A).

### [(F) Plasticizer]

Further, the inventive resist underlayer film material can contain (F) a plasticizer so as to further enhance planarizing and filling properties. The plasticizer (F) is not particularly limited, and known various types of plasticizers can be widely used. Examples thereof can include low-molecular-weight compounds, such as phthalic acid esters, adipic acid esters, phosphoric acid esters, trimellitic acid esters, and citric acid esters; and polymers, such as polyethers, polyesters, and polyacetal-based polymers disclosed in JP 2013-253227 A. When contained, the plasticizer (F) is contained in an amount of preferably 5 to 500 parts by mass, more preferably 10 to 200 parts by mass, based on 100 parts by mass of the resin having a compound shown in the general formula (1A).

### [(G) Pigment]

Furthermore, the inventive resist underlayer film material can contain (G) a pigment so as to further enhance the resolution in multilayer lithography patterning. The pigment (G) is not particularly limited, as long as the compound has appropriate absorption at exposure wavelength, and known various compounds can be widely used. Examples thereof can include benzenes, naphthalenes, anthracenes, phenanthrenes, pyrenes, isocyanuric acids, and triazines. When contained, the pigment (G) is contained in an amount of preferably 0.01 to 10 parts by mass, more preferably 0.1 to 5 parts by mass, based on 100 parts by mass of the resin having a compound shown in the general formula (1A).

Further, to the inventive resist underlayer film material, a basic compound can be added so as to enhance the storage stability. The basic compound serves as a quencher for an acid to prevent crosslinking reaction from progressing by a trace amount of an acid generated by the acid generator. Specific examples of such a basic compound can include those disclosed in paragraphs (0086) to (0090) of JP 2007-199653 A.

Moreover, to the inventive resist underlayer film material, an additive may be added besides the above-described materials so as to further enhance the filling and planarizing properties. This additive is not particularly limited, as long as filling and planarizing properties are imparted. For example, it is preferable to use liquid additives having polyethylene glycol or polypropylene glycol structures, or thermo-decomposable polymers having a weight loss ratio of 40 mass% or more between 30°C and 250°C and a weight-average molecular weight of 300 to 200,000. The thermo-decomposable polymers preferably contain a repeating unit having an acetal structure shown by the following general formula (DP1) or (DP1a). 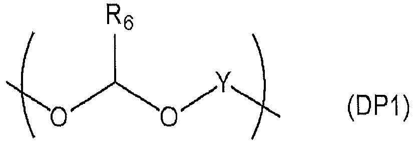 In the formula, R₆ represents a hydrogen atom or a saturated or unsaturated monovalent organic group having 1 to 30 carbon atoms optionally having a substituent. Y represents a saturated or unsaturated divalent organic group having 2 to 30 carbon atoms. 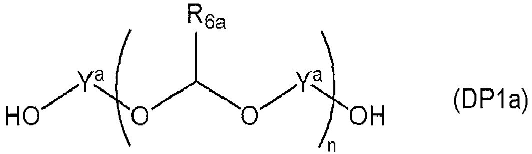 In the formula, R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

As described above, the inventive resist underlayer film material uses the resin having a compound shown in the general formula (1A) in such a manner as to control: the proportion of organic groups, such as an allyl group or a propargyl group, contributing to the flowability enhancement; and the proportion of hydroxyl groups contributing to enhancements of substrate adhesiveness and heat resistance. This makes it possible to provide a material having all of filling and planarizing properties, substrate adhesiveness, and heat resistance at high levels. Thus, the inventive resist underlayer film material is quite useful as a resist underlayer film material for multilayer resist processes, such as 2-layer resist process, 3-layer resist process using a resist middle layer film or inorganic hard mask middle layer film, and 4-layer resist process using a resist middle layer film or inorganic hard mask middle layer film and an organic thin film.

### [Patterning Processes]

Moreover, the present invention provides a patterning process for forming a pattern in a substrate to be processed, the process including steps of:
(I-1) applying the above-described resist underlayer film material onto the substrate to be processed, followed by heating to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(I-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed (2-layer resist process).

Further, the present invention provides a patterning process for forming a pattern in a substrate to be processed, the process including steps of:
(II-1) applying the above-described resist underlayer film material onto the substrate to be processed, followed by heating to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed (3-layer resist process).

In addition, the present invention provides a patterning process for forming a pattern in a substrate to be processed, the process including steps of:
(III-1) applying the above-described resist underlayer film material onto the substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed (4-layer resist process).

The thickness of the resist underlayer film utilized in the present invention is appropriately selected, and is preferably 50 to 5,000 nm, particularly preferably 100 to 2,000 nm, more preferably 100 to 1,000 nm. When the resist underlayer film is used for 3-layer process, a resist middle layer film containing silicon and a resist upper layer film containing no silicon can be formed thereon. When the resist underlayer film is used for 2-layer process, a resist upper layer film containing silicon or a resist upper layer film containing no silicon can be formed thereon.

The patterning processes according to the present invention are suitably employed in multilayer resist processes: silicon-involving 2-layer resist process; 3-layer resist process using a resist middle layer film; 4-layer resist process using an inorganic hard mask middle layer film and an organic thin film; or silicon-free 2-layer resist process.

### [3-Layer Resist Process]

Hereinbelow, the inventive patterning processes will be described by illustrating a 3-layer resist process as an example, but are not limited to this process. In this case, the above-described resist underlayer film material is used to form a resist underlayer film on a substrate. On the resist underlayer film, a resist middle layer film is formed using a resist middle layer film material containing silicon atoms. On the resist middle layer film, a resist upper layer film is formed using a resist upper layer film material as a photoresist composition, so that a multilayer resist film is formed. A pattern circuit region of the resist upper layer film is subjected to exposure and then development with a developer to form a resist pattern in the resist upper layer film. Using the pattern-formed resist upper layer film as a mask, the resist middle layer film is etched. Using the pattern-formed resist middle layer film as a mask, the resist underlayer film is etched. Further, using the pattern-formed resist underlayer film as a mask, the substrate is processed. In this manner, the pattern can be formed in the substrate.

The resist middle layer film containing silicon atoms exhibits resistance to etching with an oxygen gas or a hydrogen gas. Thus, when the resist underlayer film is etched as described above using the resist middle layer film as the mask, an etching gas mainly containing an oxygen gas or a hydrogen gas is preferably used for the etching.

Moreover, according to the inventive patterning process, a pattern can be formed in a substrate as follows. Specifically, at least, a substrate is prepared to have: a resist underlayer film formed thereon by using the above-described resist underlayer film material; an inorganic hard mask middle layer film selected from a silicon oxide film, a silicon nitride film, and a silicon oxynitride film, and formed on the resist underlayer film; and a resist upper layer film formed on the inorganic hard mask middle layer film by using a resist upper layer film material as a photoresist composition. A pattern circuit region of the resist upper layer film is subjected to exposure and development with a developer to form a resist pattern in the resist upper layer film. Using the obtained resist pattern as an etching mask, the inorganic hard mask middle layer film is etched. Using the resulting inorganic hard mask middle layer film pattern as an etching mask, the resist underlayer film is etched. Using the resulting resist underlayer film pattern as a mask, the substrate is processed to thus pattern the substrate.

In the case where an inorganic hard mask middle layer film is formed on the resist underlayer film as described above, a silicon oxide film, a silicon nitride film, and a silicon oxynitride film (SiON film) can be formed by a CVD method, an ALD method, or the like. The method for forming the nitride film is disclosed in JP 2002-334869 A and WO 2004/066377 A1. The film thickness of the inorganic hard mask middle layer film is preferably 5 to 3,000 nm, more preferably 10 to 2,000 nm. Above all, a SiON film is the most effective as an antireflective coating and is most preferably used in ArF exposure application.

As the resist middle layer film in the 3-layer resist process, a polysilsesquioxane-based resist middle layer film can be used suitably. The polysilsesquioxane-based resist middle layer film is readily provided with an antireflective effect in excimer exposure. Thereby, there are such advantages of satisfactorily suppressing reflection light in pattern exposure of the resist upper layer film, and achieving excellent resolution. Particularly, for 193-nm light exposure, if a material containing many aromatic groups is used as a resist underlayer film, the k-value and thus the substrate reflection are increased. However, the reflection can be suppressed by the resist middle layer film, and so the substrate reflection can be reduced to 0.5% or less. As the resist middle layer film having the antireflective effect, a polysilsesquioxane is preferably used, the polysilsesquioxane having anthracene for 248-nm and 157-nm light exposure, or a phenyl group or a light-absorbing group having a silicon-silicon bond for 193-nm light exposure in a pendant structure, and being crosslinked by an acid or heat.

In this case, forming a resist middle layer film by a spin-coating method is simpler and more advantageous regarding cost than a CVD method.

The resist upper layer film in the 3-layer resist film may be a positive type or a negative type, and any generally-used photoresist composition can be employed. When the resist upper layer film is formed from the photoresist composition, a spin-coating method is preferably employed as in the case of forming the resist underlayer film. After spin-coating of the photoresist composition, pre-baking is preferably performed at 60 to 180°C for 10 to 300 seconds. Then, light exposure, post-exposure bake (PEB), and development are performed according to conventional methods to obtain the resist pattern. Note that the thickness of the resist upper layer film is not particularly limited, but is preferably 10 to 500 nm, and 20 to 400 nm is particularly preferable.

Additionally, examples of exposure light can include a high-energy beam with a wavelength of 300 nm or less, specifically, excimer laser of 248 nm, 193 nm, and 157 nm, soft X-ray of 3 to 20 nm, electron beam, X-ray, etc.

Next, etching is performed using the obtained resist pattern as a mask. In the 3-layer process, the resist middle layer film can be etched using a fluorocarbon-based gas and using the resist pattern as the mask. Then, the resist underlayer film is etched using an oxygen gas or a hydrogen gas and using the resist middle layer film pattern as the mask.

Subsequently, the substrate to be processed can be etched according to a conventional method. For example, the substrate made of SiO₂, SiN, or silica-based low-dielectric insulating film is etched mainly with a fluorocarbon-based gas; and p-Si, Al, or W is etched mainly with a chlorine- or bromine-based gas. When the substrate is processed by etching with a fluorocarbon-based gas, the resist middle layer film in the 3-layer process is removed when the substrate is processed. When the substrate is etched with a chlorine- or bromine-based gas, the resist middle layer film needs to be removed by, for example, additional dry etching with a fluorocarbon-based gas after the substrate processing.

Note that as the substrate to be processed, a layer to be processed may be formed on a substrate. The substrate is not particularly limited, and examples thereof include substrates made of Si, α-Si, p-Si, SiO₂, SiN, SiON, W, TiN, Al, or the like. A material different from that of the layer to be processed is selected. Examples of the layer to be processed include: various Low-k films made of Si, SiO₂, SiON, SiN, p-Si, α-Si, W, TiN, W-Si, Al, Cu, Al-Si, or the like; and stopper films thereof. The layer is formed to have a thickness of generally 50 to 15,000 nm, in particular, 100 to 10,000 nm.

The substrate to be processed that is used in the inventive patterning processes is preferably a substrate having a structure or step with a height of 30 nm or more. Since the inventive resist underlayer film material is excellent in filling and planarizing properties as described above, even if the substrate to be processed has a structure or step (unevenness) with a height of 30 nm or more, a flat cured film can be formed. The structure or step of the substrate to be processed has a height of preferably 30 nm or more, more preferably 100 nm or more, further preferably 200 nm or more, particularly preferably 300 nm or more. In a method of processing a stepped substrate having a pattern with such a height, a film is formed from the inventive resist underlayer film material to fill/planarize the pattern, enabling the resist middle layer film and the resist upper layer film formed thereafter to have uniform film thicknesses. Thus, exposure depth margin (depth of focus: DOF) in photolithography is readily secured and very preferable. Additionally, since the inventive resist underlayer film material is excellent in adhesiveness to a substrate, the effects are particularly exhibited in filling/planarizing a pattern structure with high aspect ratio. The pattern aspect ratio is preferably 3 or more, more preferably 5 or more, further preferably 10 or more.

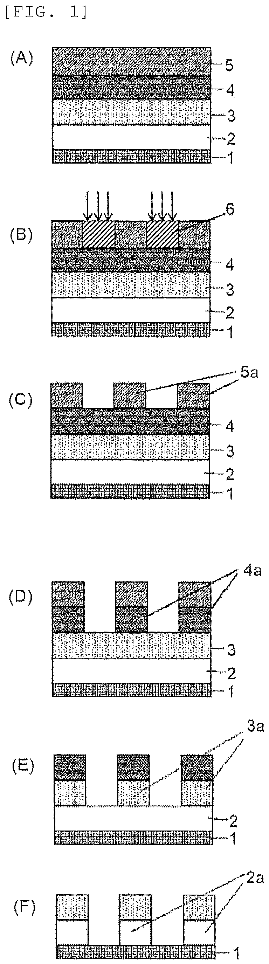

Hereinbelow, an example of the 3-layer resist process will be specifically described with reference to FIG. 1. As shown in FIG. 1 (A), in the 3-layer resist process, a resist underlayer film 3 is formed on a layer 2 to be processed that has been stacked on a substrate 1 to be processed. Then, a resist middle layer film 4 is formed, and a resist upper layer film 5 is formed thereon.

Next, as shown in FIG. 1 (B), an exposure portion 6 of the resist upper layer film is exposed to light, followed by PEB (baking after exposure) and development to form a resist upper layer film pattern 5a (FIG. 1 (C)). While using the obtained resist upper layer film pattern 5a as a mask, the resist middle layer film 4 is etched with a CF-based gas. Thereby, a resist middle layer film pattern 4a is formed (FIG. 1 (D)). After the resist upper layer film pattern 5a is removed, the resist underlayer film 3 is etched with oxygen or hydrogen plasma while using the obtained resist middle layer film pattern 4a as a mask. Thereby, a resist underlayer film pattern 3a is formed (FIG. 1 (E)). Further, after the resist middle layer film pattern 4a is removed, the layer 2 to be processed is etched while using the resist underlayer film pattern 3a as a mask. Thus, a pattern 2a is formed (FIG. 1 (F)).

When an inorganic hard mask middle layer film is used, the resist middle layer film 4 is the inorganic hard mask middle layer film, and when an organic thin film is formed, the organic thin film is disposed between the resist middle layer film 4 and the resist upper layer film 5. The etching of the organic thin film may be performed continuously before the etching of the resist middle layer film 4. Alternatively, after the organic thin film is etched alone, the etching apparatus is changed, for example, and then the resist middle layer film 4 may be etched.

### [4-Layer Resist Process]

Furthermore, the present invention is suitably applicable to a 4-layer resist process using an organic thin film. In this case, at least, a substrate is prepared to have: a resist underlayer film formed thereon by using the above-described resist underlayer film material; an inorganic hard mask middle layer film selected from a silicon oxide film, a silicon nitride film, and a silicon oxynitride film, and formed on the resist underlayer film; an organic thin film formed on the inorganic hard mask middle layer film; and a resist upper layer film formed on the organic thin film by using a resist upper layer film material as a photoresist composition. A pattern circuit region of the resist upper layer film is subjected to exposure and then development with a developer to form a resist pattern in the resist upper layer film. Using the obtained resist pattern as an etching mask, the organic thin film and the inorganic hard mask middle layer film are etched. Using the resulting inorganic hard mask middle layer film pattern as an etching mask, the resist underlayer film is etched. Using the resulting resist underlayer film pattern as a mask, the substrate is processed, so that the pattern can be formed in the substrate.

On the inorganic hard mask middle layer film, a photoresist film may be formed as the resist upper layer film. Alternatively, after an organic thin film is formed on the inorganic hard mask middle layer film as described above by spin coating, the photoresist film may be formed on the organic thin film. When a SiON film is used as the inorganic hard mask middle layer film and an organic antireflective coating (BARC) having a light-absorbing group at the exposure wavelength is used as the organic thin film, the two layers of antireflective coating including the SiON film and the organic thin film in excimer exposure make it possible to suppress the reflection even in liquid immersion exposure at a high NA exceeding 1.0. Another advantage in forming the organic thin film is having an effect of reducing footing of the photoresist pattern immediately above the SiON film. Moreover, when an adhesion film (ADL) having excellent affinity to the upper layer photoresist is used as the organic thin film, there is also such an advantage that pattern collapse of the photoresist can be suppressed.

### [Methods for Forming Resist Underlayer Film]

The present invention provides a method for forming a resist underlayer film that serves as an organic planarizing film employed in a semiconductor device manufacturing process, the method including:
spin-coating a substrate to be processed with the above-described resist underlayer film material; and
heating the substrate coated with the resist underlayer film material at a temperature of 100°C or higher and 600°C or lower for 10 to 600 seconds to form a cured film.

The present invention also provides a method for forming a resist underlayer film that serves as an organic planarizing film employed in a semiconductor device manufacturing process, the method including:
spin-coating a substrate to be processed with the above-described resist underlayer film material; and
heating the substrate coated with the resist underlayer film material under an atmosphere with an oxygen concentration of 1% or more and 21% or less to form a cured film.

Alternatively, the present invention provides a method for forming a resist underlayer film that serves as an organic planarizing film employed in a semiconductor device manufacturing process, the method including:
spin-coating a substrate to be processed with the above-described resist underlayer film material; and
heating the substrate coated with the resist underlayer film material under an atmosphere with an oxygen concentration of less than 1% to form a cured film.

In the inventive methods for forming a resist underlayer film, a substrate to be processed is coated with the above-described resist underlayer film material by a spin-coating method etc. By employing a method like spin-coating method, favorable filling property can be obtained. After the spin-coating, baking is performed to evaporate the organic solvent and to promote the crosslinking reaction, thereby preventing the mixing with a resist upper layer film or a resist middle layer film. The baking is performed in a temperature range of preferably 100°C or higher to 600°C or lower, more preferably 100°C or higher to 450°C or lower, further preferably 150°C or higher to 400°C or lower. The baking time is in a range of preferably 10 seconds to 600 seconds, more preferably 10 to 300 seconds. Appropriately adjusting the baking temperature and time within the above ranges can make planarizing, filling, and curing properties, such as dry etching resistance and heat resistance suitable for use. With the baking temperature at 100°C or higher, curing proceeds sufficiently, preventing mixing with a resist upper layer film or resist middle layer film. With the baking temperature at 600°C or lower, not only thermal decomposition of the base resin but also the film thickness reduction can be suppressed, and the film surface becomes uniform.

As the atmosphere during baking, any of oxygen-containing atmosphere (oxygen concentration: 1% to 21%), as in air, and oxygen-free atmosphere, as in nitrogen, can be selected as necessary. For example, if a substrate to be processed is susceptible to oxidation in air, the substrate damage can be suppress by forming a cured film through heating under an atmosphere with an oxygen concentration of less than 1%.

The substrate to be processed that is used in the inventive methods for forming a resist underlayer film is preferably a substrate to be processed which has a structure or step with a height of 30 nm or more. Since the inventive resist underlayer film material is excellent in filling and planarizing properties as described above, even if the substrate to be processed has a structure or step (unevenness) with a height of 30 nm or more, a flat cured film can be formed. The structure or step of the substrate to be processed has a height of preferably 30 nm or more, more preferably 100 nm or more, further preferably 200 nm or more, particularly preferably 300 nm or more. In a method of processing a stepped substrate having a pattern with such a height, a film formed from the inventive resist underlayer film material fills/planarizes the pattern, enabling the resist middle layer film and the resist upper layer film formed thereafter to have uniform film thicknesses. Thus, exposure depth margin (DOF) in photolithography is readily secured and very preferable. In addition, since the inventive resist underlayer film material is excellent in adhesiveness to a substrate,
the effects are particularly exhibited in filling/planarizing a pattern structure with high aspect ratio. The pattern aspect ratio is preferably 3 or more, more preferably 5 or more, further preferably 10 or more.

### EXAMPLE

Hereinafter, the present invention will be specifically described with reference to Examples and Comparative Examples. However, the present invention is not limited to these descriptions. Note that molecular weight and dispersity were measured by the following methods. Weight-average molecular weight (Mw) and dispersity (Mw/Mn) were determined in terms of polystyrene by gel permeation chromatography (GPC) using tetrahydrofuran as an eluent.

### [Synthesis Examples]

The following Compounds G: (G1) to (G7) and Modification agents H: (H1) to (H3) were used in Synthesis Examples below.
Compounds G: (G1) to (G7) are shown below.

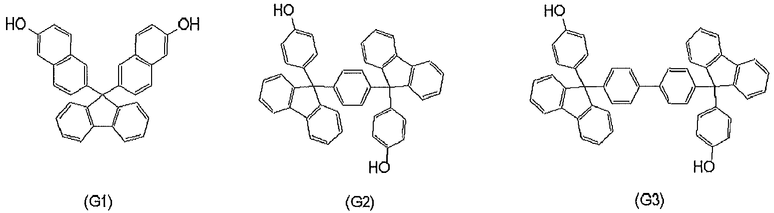

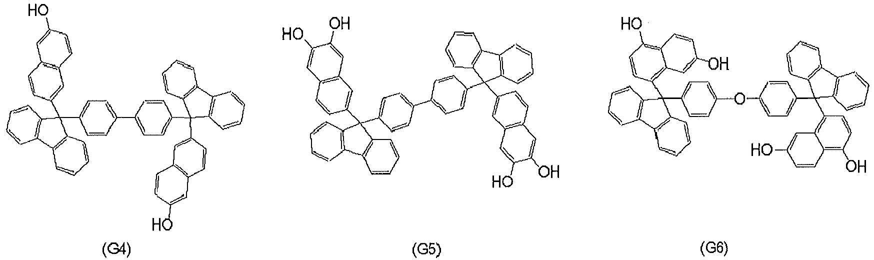

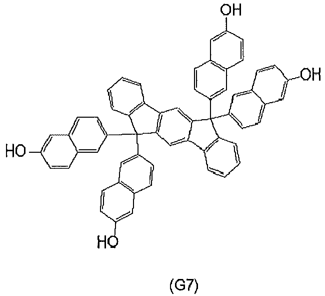

Modification agents H: (H1) to (H3) are shown below.

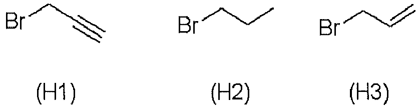

### [Synthesis Example 1] Synthesis of Compound (A-1)

Under nitrogen atmosphere, 44.7 g of Compound (G1), 16.5 g of potassium carbonate, and 150 g of DMF were added together to prepare a homogeneous dispersion with an inner temperature of 50°C. Then, 16.5 g of Modification agent (H1) was slowly added thereto, and the reaction was allowed to proceed with the inner temperature of 50°C for 24 hours. To the reaction solution, 300 ml of methyl isobutyl ketone and 300 g of pure water were added to dissolve the deposited salt. Subsequently, the separated aqueous layer was removed. Further, the organic layer was washed six times with 100 g of a 3% nitric acid aqueous solution and 100 g of pure water. Thereafter, the organic layer was dried under reduced pressure. Thus, Compound (A-1) was obtained.

When the weight-average molecular weight (Mw) and dispersity (Mw/Mn) were determined by GPC, the following results were obtained.
(A-1): Mw=542, Mw/Mn=1.02

### [Synthesis Examples 2 to 14] Synthesis of Compounds (A-2) to (A-14)

Compounds (A-2) to (A-14) shown in Tables 1 to 3 were obtained under the same reaction conditions as in Synthesis Example 1, except that Compounds G, Modification agents H, and potassium carbonate were used according to the formulation amounts shown in Tables 1 to 3.

**[Table 1]**

| Synthesis Example | Compounds G | Compounds H | Potassium carbonate | Product |
|---|---|---|---|---|
| 1 | G1: 44.7g | H1: 16.5g | 16.5g | 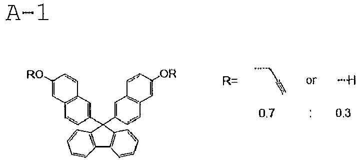 |
| 2 | G1: 47.6g | H1: 7.5g | 17.5g | 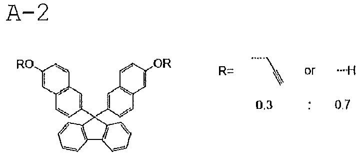 |
| 3 | G2: 46.7g | H2: 9.7g | 13.1g | 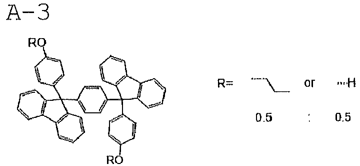 |
| 4 | G3: 47.2g | H3: 8.6g | 11.7g | 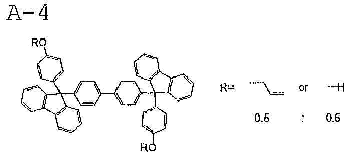 |
| 5 | G4: 46. 9g | H1: 9.0g | 10.1g | 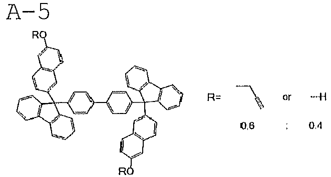 |
| 6 | G4: 48.1g | H1: 6.0g | 10.4g | 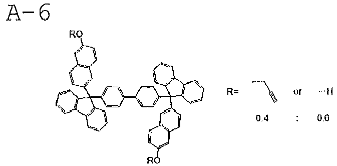 |

**[Table 2]**

| Synthesis Example | Compounds G | Compounds H | Potassium carbonate | Product |
|---|---|---|---|---|
| 7 | G5: 43. 4g | H1: 20.7g | 9.0g | 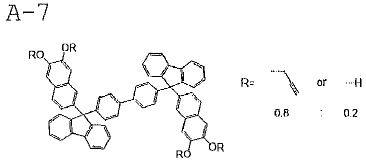 |
| 8 | G5: 48.2g | H1: 5.7g | 10.0g | 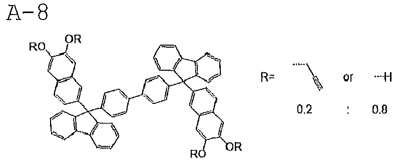 |
| 9 | G6: 45.7g | H1: 13.4g | 9.3g | 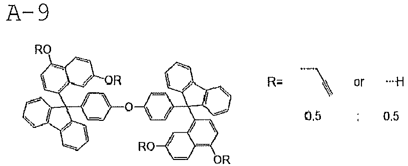 |
| 10 | G7 : 45.8g | H1: 13.2g | 9.2g | 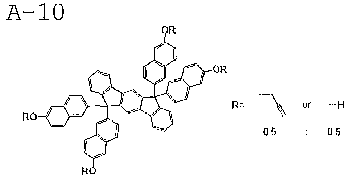 |
| 11 | G1: 42.8g | H1: 28.2g | 15.7g | 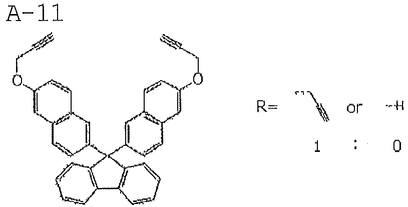 |
| 12 | G4: 45.5g | H1: 17.6g | 9.8g | 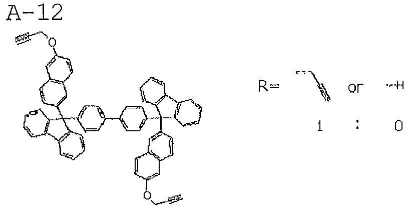 |

**[Table 3]**

| Synthesis Example | Compounds G | Compounds H | potassium carbonate | Product |
|---|---|---|---|---|
| 13 | G4 : 46.1g | H1: 12.2g | 10.0g | 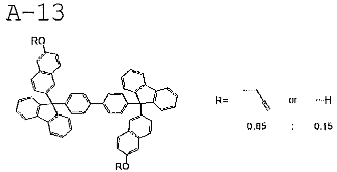 |
| 14 | G4 : 49.3g | H1: 2.3g | 10.7g | 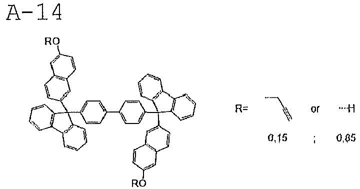 |

### [Synthesis Example 15] Synthesis of Compound (A-15)

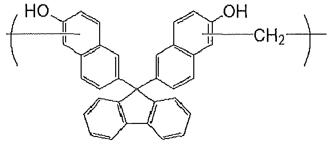

Under nitrogen atmosphere, 90.1 g of Compound (G1), 9.7 g of a 37% formalin solution, and 270 g of 2-methoxy-1-propanol were added together to prepare a homogeneous solution with a liquid temperature of 80°C. Then, 18 g of a 2-methoxy-1-propanol solution containing 20% p-toluenesulfonic acid was slowly added thereto, and stirred with the liquid temperature of 110°C for 8 hours. After cooling to room temperature, 600 g of methyl isobutyl ketone was added thereto, and the organic layer was washed five times with 200 g of pure water. Subsequently, the organic layer was dried under reduced pressure. To the residue, 320 g of THF was added, and the polymer was reprecipitated with 1350 g of hexane. The precipitated polymer was separated by filtration and dried under reduced pressure. Thus, Compound (A-15) was obtained. When the weight-average molecular weight (Mw) and dispersity (Mw/Mn) were determined by GPC, the following results were obtained.
Mw=3460, Mw/Mn=4.60

The structures, weight-average molecular weight (Mw), and dispersity (Mw/Mn) of each of the obtained compounds are shown in Tables 4 to 6. Note that Compound (A-16) employed was (G4) in Compounds G used as the raw materials of Synthesis Examples.

**[Table 4]**

| Compound | Product | Mw | Mw/Mn |
|---|---|---|---|
| A-1 | 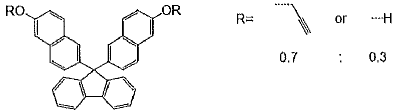 | 542 | 1.02 |
| A-2 | 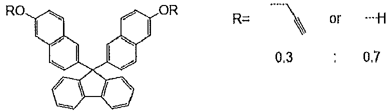 | 538 | 1.02 |
| A-3 | 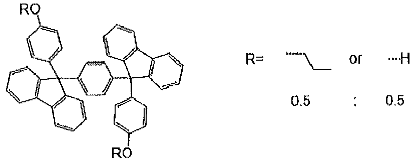 | 667 | 1.01 |
| A-4 | 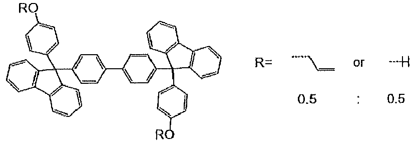 | 724 | 1. 01 |
| A-5 | 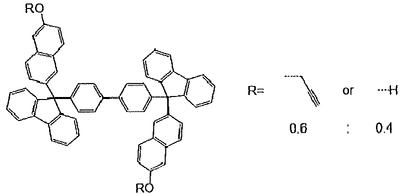 | 903 | 1.08 |
| A-6 | 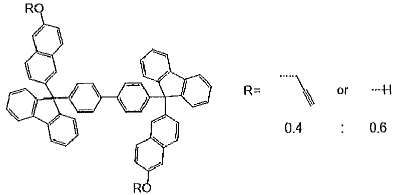 | 895 | 1.06 |

**[Table 5]**

| Compound | Product | Mw | Mw/Mn |
|---|---|---|---|
| A-7 | 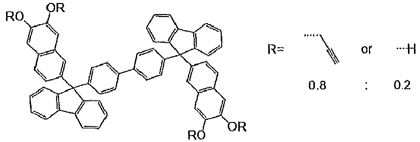 | 1015 | 1.03 |
| A-8 | 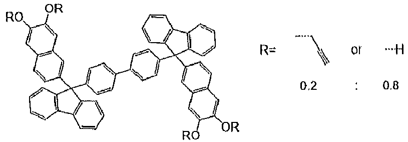 | 1010 | 1.01 |
| A-9 | 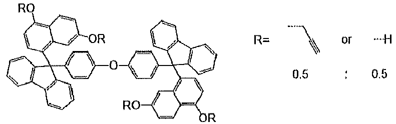 | 1050 | 1.02 |
| A-10 | 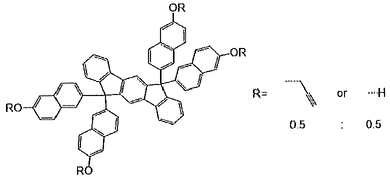 | 1038 | 1.02 |
| A-11 | 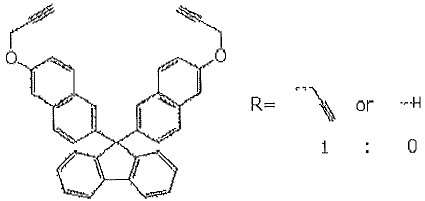 | 560 | 1.01 |

**[Table 6]**

| Compound | Product | Mw | Mw/Mn |
|---|---|---|---|
| A-12 | 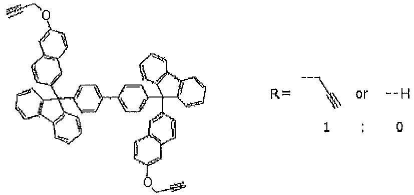 | 965 | 1.08 |
| A-13 | 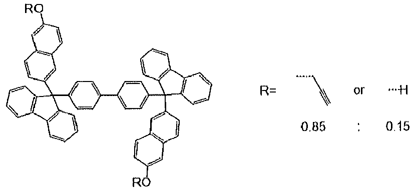 | 936 | 1.06 |
| A-14 | 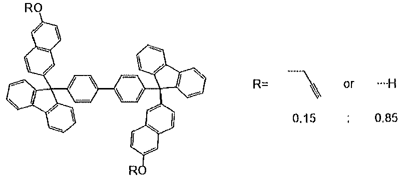 | 828 | 1.04 |
| A-15 | 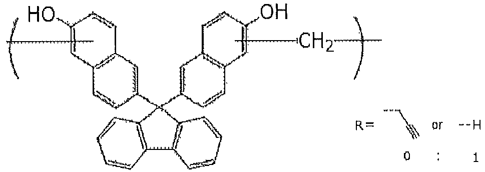 | 3460 | 4.6 |
| A-16 | 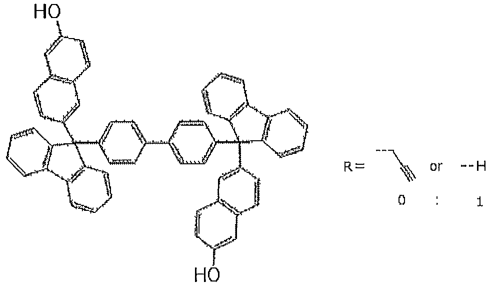 | 801 | 1.07 |

### [(C) Crosslinking Agent]

Crosslinking agents (C) used for resist underlayer film materials are shown below.

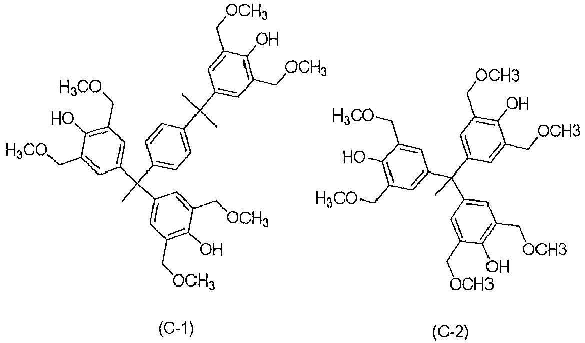

### [Resist Underlayer Film Material UL-1]

In a proportion shown in Table 7, Compound (A-1) described above was dissolved in propylene glycol monomethyl ether acetate (PGMEA) containing 0.5 mass% surfactant FC-4430 (manufactured by Sumitomo 3M Ltd.). The obtained solution was filtered through a 0.02-µm membrane filter. Thus, a resist underlayer film material (UL-1) was prepared.

### [Resist Underlayer Film Materials UL-2 to 15 and Comparative UL-1 to 7]

Chemical solutions were prepared by the same operation as for UL-1, except that the kinds and contents of the components were as shown in Table 7. Note that, in Table 7, "-" indicates that the corresponding component was not used. (E-1) of the following formula was used as an acid generator (TAG), and 1,6-diacetoxyhexane with a boiling point of 260°C was used as a high-boiling-point solvent (B-2).

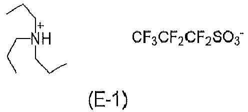

### (thermal acid generator)

**[Table 7]**

| Composition | (A) Resin | | (C) Crosslinking agent | | High-boiling-point solvent | | (E) Acid generator | | (B) Solvent | |
|---|---|---|---|---|---|---|---|---|---|---|
| | (parts by mass) | | (parts by mass) | | (parts by mass) | | (parts by mass) | | (parts by mass) | |
| UL-1 | A-1 | 100 | - | - | - | - | - | - | PGMEA | 550 |
| UL-2 | A-2 | 100 | - | - | - | - | - | - | PGMEA | 550 |
| UL-3 | A-3 | 100 | - | - | - | - | - | - | PGMEA | 550 |
| UL-4 | A-4 | 100 | - | - | - | - | - | - | PGMEA | 550 |
| UL-5 | A-5 | 100 | - | - | - | - | - | - | PGMEA | 550 |
| UL-6 | A-6 | 100 | - | - | - | - | - | - | PGMEA | 550 |
| UL-7 | A-7 | 100 | - | - | - | - | - | - | PGMEA | 550 |
| UL-8 | A-8 | 100 | - | - | - | - | - | - | PGMEA | 550 |
| UL-9 | A-9 | 100 | - | - | - | - | - | - | PGMEA | 550 |
| UL-10 | A-10 | 100 | - | - | - | - | - | - | PGMEA | 550 |
| UL-11 | A-5 | 100 | C-1 | 20 | - | - | - | - | PGMEA | 550 |
| UL-12 | A-6 | 100 | C-2 | 20 | - | - | - | - | PGMEA | 550 |
| UL-13 | A-12/ A-16 | 30/ 70 | - | - | - | - | - | - | PGMEA | 550 |
| UL-14 | A-12/ A-16 | 70 /30 | - | - | - | - | - | - | PGMEA | 550 |
| UL-15 | A-1 | 100 | C-1 | 50 | B-2 | 50 | E-1 | 2 | PGMEA | 500 |
| Comparative UL-1 | A-11 | 100 | - | - | - | - | - | - | PGMEA | 550 |
| Comparative UL-2 | A-12 | 100 | - | - | - | - | - | - | PGMEA | 550 |
| Comparative UL-3 | A-13 | 100 | - | - | - | - | - | - | PGMEA | 550 |
| Comparative UL-4 | A-14 | 100 | - | - | - | - | - | - | PGMEA | 550 |
| Comparative UL-5 | A-15 | 100 | - | - | - | - | - | - | PGMEA | 550 |
| Comparative UL-6 | A-16 | 100 | - | - | - | - | - | - | PGMEA | 550 |
| Comparative UL-7 | A-11/ A-15 | 70/ 30 | - | - | - | - | - | - | PGMEA | 550 |

### [Heat Resistance Evaluation]

The resist underlayer film materials (UL-1 to -15 and Comparative UL-1 to -7) were each applied onto a silicon substrate and baked at 400°C for 60 seconds to form a resist underlayer film having a film thickness of approximately 600 nm. A film thickness T1 after the 400°C baking was measured. These substrates were further treated by baking at 550°C for 60 seconds under such a nitrogen stream that the oxygen concentration was controlled to 0.2% or less. A film thickness T2 after the 550°C baking was measured. Based on these measurement results, a film reduction ratio was calculated by T2/T1. If the value of the film reduction ratio [T2/T1] was 95% or more, the material was evaluated as "A" (quite favorable). If the value was 90% or more but less than 95%, the material was evaluated as "B" (favorable). If the value was less than 90%, the material was evaluated as "C" (poor). Table 8 shows the result.

**[Table 8]**

| | Composition | Heat resistance | | | |
|---|---|---|---|---|---|
| | | film thickness T1 (nm) after 400°C baking | film thickness T2 (nm) after 550°C baking | film reduction ratio(%) [T2/T1] | result |
| Example 1-1 | UL-1 | 602.8 | 554.6 | 92% | B |
| Example 1-2 | UL-2 | 605.4 | 569.1 | 94% | B |
| Example 1-3 | UL-3 | 600.8 | 570.8 | 95% | A |
| Example 1-4 | UL-4 | 608.1 | 577.7 | 95% | A |
| Example 1-5 | UL-5 | 600.5 | 570.5 | 95% | A |
| Example 1-6 | UL-6 | 603.4 | 585.3 | 97% | A |
| Example 1-7 | UL-7 | 602.5 | 572.4 | 95% | A |
| Example 1-8 | UL-8 | 604.8 | 592.7 | 98% | A |
| Example 1-9 | UL-9 | 599.7 | 575.7 | 96% | A |
| Example 1-10 | UL-10 | 606.2 | 588.0 | 97% | A |
| Example 1-11 | UL-11 | 604.2 | 592.1 | 98% | A |
| Example 1-12 | UL-12 | 601.8 | 595.8 | 99% | A |
| Example 1-13 | UL-13 | 603.6 | 591.5 | 98% | A |
| Example 1-14 | UL-14 | 597.8 | 561.9 | 94% | B |
| Example 1-15 | UL-15 | 592.5 | 557.0 | 94% | B |
| Comparative Example 1-1 | Comparative UL-1 | 602.5 | 542.3 | 90% | B |
| Comparative Example 1-2 | Comparative UL-2 | 600.2 | 552.2 | 92% | B |
| Comparative Example 1-3 | Comparative UL-3 | 600.5 | 552.5 | 92% | B |
| Comparative Example 1-4 | Comparative UL-4 | 605.3 | 599.2 | 99% | A |
| Comparative Example 1-5 | Comparative UL-5 | 601.1 | 577.1 | 96% | A |
| Comparative Example 1-6 | Comparative UL-6 | 601.5 | 595.5 | 99% | A |
| Comparative Example 1-7 | Comparative UL-7 | 605.7 | 563.3 | 93% | B |

It was found as shown in Table 8 that the inventive resist underlayer film materials (Examples 1-1 to 1-15) had film thickness reductions after the 550°C baking as small as 10% or less, and had heat resistance to at least 550°C. Among these, the heat resistance was favorable in Examples 1-3 to 1-10 containing compounds having two cardo structures. Further, the results of Examples 1-11 and 1-12 respectively prepared in combination with crosslinking agents demonstrated more excellent heat resistance. This is presumably because incorporating such crosslinking agents allows the crosslinking reaction of the resins to progress high-dimensionally, enabling formation of cured films having high crosslinking density. The comparison among Examples 1-5 to 1-6, Examples 1-13 to 1-14, Comparative Examples 1-2 to 1-4, and Comparative Example 1-6, which had the same skeleton structure but different constituent ranges of R1, showed that the higher the proportion of hydroxyl groups, the more excellent the heat resistance the resulting film had.

### [Filling Property Evaluation]

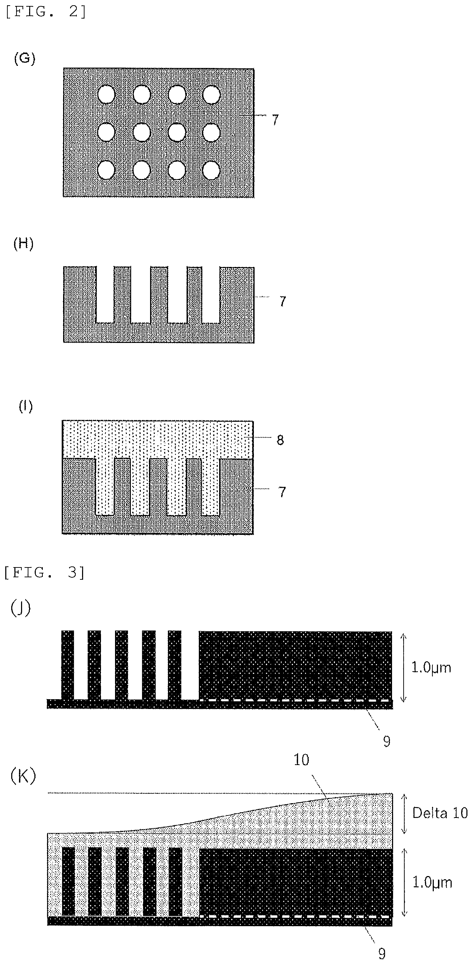

The resist underlayer film materials (UL-1 to -15 and Comparative UL-1 to -7) were each applied onto a SiO₂ wafer substrate having an HMDS-treated dense hole pattern (hole diameter: 0.2 µm, hole depth: 1.0 µm, distance between the centers of two adjacent holes: 0.4 µm) and heated using a hot plate at 400°C for 60 seconds to form a resist underlayer film A. Meanwhile, a resist underlayer film B different from the resist underlayer film A was formed by baking at 550°C for 60 seconds under a nitrogen stream with the oxygen concentration controlled to 0.2% or less. The substrates thus used were base substrates 7 (SiO₂ wafer substrates) each having a dense hole pattern as shown in FIG. 2 (G) (top view) and (H) (sectional view). The sectional shapes of the resulting wafer substrates were observed with an electron microscope (S-4700) manufactured by Hitachi, Ltd. to check whether the insides of the holes were filled with the resist underlayer film without voids (space), and whether peeling occurred at the interface between the resist underlayer film and the substrate. Table 9 shows the results. If a resist underlayer film material inferior in filling property is used in this evaluation, voids occur inside the holes. Moreover, if a resist underlayer film material inferior in adhesiveness is used in this evaluation, peeling occurs at the interface between the resist underlayer film and the substrate. If a resist underlayer film material having favorable filling property and favorable adhesiveness to the substrate is used in this evaluation, the base substrate 7 having a dense hole pattern is filled with a resist underlayer film 8 with neither voids in the holes nor peeling from the substrate as shown in FIG. 2 (I).

**[Table 9]**

| | Composition | Presence or absence of voids /peeling | |
|---|---|---|---|
| | | 400°C baking | 550°C baking |
| Example 2-1 | UL-1 | absent | absent |
| Example 2-2 | UL-2 | absent | absent |
| Example 2-3 | UL-3 | absent | absent |
| Example 2-4 | UL-4 | absent | absent |
| Example 2-5 | UL-5 | absent | absent |
| Example 2-6 | UL-6 | absent | absent |
| Example 2-7 | UL-7 | absent | absent |
| Example 2-8 | UL-8 | absent | absent |
| Example 2-9 | UL-9 | absent | absent |
| Example 2-10 | UL-10 | absent | absent |
| Example 2-11 | UL-11 | absent | absent |
| Example 2-12 | UL-12 | absent | absent |
| Example 2-13 | UL-13 | absent | absent |
| Example 2-14 | UL-14 | absent | absent |
| Example 2-15 | UL-15 | absent | absent |
| Comparative Example 2-1 | Comparative UL-1 | peeled | peeled |
| Comparative Example 2-2 | Comparative UL-2 | peeled | peeled |
| Comparative Example 2-3 | Comparative UL-3 | peeled | peeled |
| Comparative Example 2-4 | Comparative UL-4 | voids occurred | voids occurred |
| Comparative Example 2-5 | Comparative UL-5 | voids occurred | voids occurred |
| Comparative Example 2-6 | Comparative UL-6 | voids occurred | voids occurred |
| Comparative Example 2-7 | Comparative UL-7 | voids occurred | voids occurred |

It was found as shown in Table 9 that the filling properties after the 400°C and 550°C baking were favorable in Examples 2-1 to 2-15 using the inventive resist underlayer film materials (UL-1 to -15). This is because the compounds shown in the general formula (1A) were used in which the component (A) as a whole satisfies the relations of a+b=1 and 0.2≤b≤0.8, where "a" represents the proportion of hydrogen atoms, and "b" represents the proportion of alkyl groups having 1 to 10 carbon atoms or structures shown in the general formula (1C), among the structures constituting R₁ incorporated in the general formula (1B).

Meanwhile, Compounds A-12 and A-16 do not satisfy these relations individually, but blended in such a manner as to satisfy the relations in Examples 2-13 and 2-14. In these cases, it was found that the filling properties after the 400°C and 550°C baking were favorable. In this manner, even if the compounds shown by the general formula (1A) and incorporated in the inventive resist underlayer film materials do not satisfy the relations singly, when the relations are satisfied by the component (A) as a whole, resist underlayer film materials having favorable filling properties after 400°C and 550°C baking can be provided.

In contrast, in Comparative Examples 2-4 and 2-6, the proportion of "b" among the structures constituting R₁ was less than 0.2, the flowability was insufficient, and voids were observed in all the cases after the 400°C and 550°C baking. In Comparative Examples 2-1 to 2-3, since the proportion of "b" exceeded 0.8, the adhesiveness to the substrate was insufficient, and the peeling of the resist underlayer films from the substrate was observed in all the cases after the 400°C and 550°C baking. Further, in Comparative Examples 2-5 and 2-7 containing the polymer, the molecular weight of the resin was so high that the flowability was insufficient, and voids were observed in all the cases after the 400°C and 550°C baking.

From these results, the inventive resist underlayer film materials make it possible to provide resist underlayer film materials having both filling property and substrate adhesiveness at high levels by using the resin having a compound in such a manner as to control proportions of: organic groups contributing to flowability enhancement; and hydroxyl groups contributing to substrate adhesiveness enhancement.

### [Planarizing Property Evaluation]

The resist underlayer film materials (UL-1 to -15 and Comparative UL-1 to -7) were each applied onto a SiO₂ wafer substrate having an HMDS-treated dense hole pattern (hole diameter: 0.2 µm, hole depth: 1.0 µm, distance between the centers of two adjacent holes: 0.4 µm) and baked using a hot plate at 400°C for 60 seconds to form a resist underlayer film. The substrates thus used were base substrates 9 (SiO₂ wafer substrates) each having a dense hole pattern as shown in FIG. 3 (J). The sectional shapes of the resulting wafer substrates were observed with a scanning electron microscope (SEM), and a step (Delta 10 in FIG. 3 (K)) between a hole-pattern dense portion and a hole-pattern-free portion of each resist underlayer film 10 was observed with an electron microscope (S-4700) manufactured by Hitachi, Ltd. In this evaluation, the smaller the step, the more favorable the planarizing property. Note that, in this evaluation, a hole pattern with depths of 1.0 µm was planarized using a resist underlayer film material generally having a film thickness of approximately 600 nm. This is a strict evaluation condition to evaluate the planarizing property. If the step of the resist underlayer film was less than 300 nm, the material was evaluated as "A" (quite favorable). If the step was 300 nm or more but less than 350 nm, the material was evaluated as "B" (favorable). If the step was 350 nm or more or peeling of the resist underlayer film from the substrate was observed, the material was evaluated as "C" (poor). Table 10 shows the result.

**[Table 10]**

| | Composition | Planarizing property | | |
|---|---|---|---|---|
| | | baking temperature | step (nm) | evaluation |
| Example 3-1 | UL-1 | 400°C | 275 | A |
| Example 3-2 | UL-2 | 400°C | 280 | A |
| Example 3-3 | UL-3 | 400°C | 275 | A |
| Example 3-4 | UL-4 | 400°C | 270 | A |
| Example 3-5 | UL-5 | 400°C | 285 | A |
| Example 3-6 | UL-6 | 400°C | 290 | A |
| Example 3-7 | UL-7 | 400°C | 320 | B |
| Example 3-8 | UL-8 | 400°C | 325 | B |
| Example 3-9 | UL-9 | 400°C | 315 | B |
| Example 3-10 | UL-10 | 400°C | 320 | B |
| Example 3-11 | UL-11 | 400°C | 260 | A |
| Example 3-12 | UL-12 | 400°C | 265 | A |
| Example 3-13 | UL-13 | 400°C | 310 | B |
| Example 3-14 | UL-14 | 400°C | 300 | B |
| Example 3-15 | UL-15 | 400°C | 260 | A |
| Comparative Example 3-1 | Comparative UL-1 | 400°C | peeled | C |
| Comparative Example 3-2 | Comparative UL-2 | 400°C | peeled | C |
| Comparative Example 3-3 | Comparative UL-3 | 400°C | peeled | C |
| Comparative Example 3-4 | Comparative UL-4 | 400°C | 355 | C |
| Comparative Example 3-5 | Comparative UL-5 | 400°C | 380 | C |
| Comparative Example 3-6 | Comparative UL-6 | 400°C | 360 | C |
| Comparative Example 3-7 | Comparative UL-7 | 400°C | 350 | C |

It was found as shown in Table 10 that the planarizing property for the dense hole pattern after the 400°C baking was favorable in Examples 3-1 to 3-15 using the inventive resist underlayer film materials (UL-1 to -15). This is because the compounds shown in the general formula (1A) were used in which the component (A) as a whole satisfies the relations of a+b=1 and 0.2≤b≤0.8, where "a" represents the proportion of hydrogen atoms, and "b" represents the proportion of alkyl groups having 1 to 10 carbon atoms or structures shown in the general formula (1C), among the structures constituting R₁ incorporated in the general formula (1B).

Meanwhile, Compounds A-12 and A-16 do not satisfy these relations individually, but blended in such a manner as to satisfy the relations in Examples 3-13 and 3-14. In these cases, it was found that the planarizing property after the 400°C baking was favorable. In this manner, even if the compounds shown by the general formula (1A) incorporated in the inventive resist underlayer film materials do not satisfy the relations singly, when the relations are satisfied by the component (A) as a whole, resist underlayer film materials having favorable planarizing property after 400°C baking can be provided.

In contrast, in Comparative Examples 3-4 and 3-6, the proportion of "b" among the structures constituting R₁ was less than 0.2, the flowability was insufficient, and planarizing property degradation was observed. In Comparative Examples 3-1 to 3-3, since the proportion of "b" exceeded 0.8, the adhesiveness to the substrate was insufficient, and, peeling of the resist underlayer films from the substrate was observed. Further, in Comparative Examples 3-5 and 3-7 containing the polymer, the flowability was insufficient, so that planarizing property degradation was observed.

The comparison among Example 3-5, Example 3-6, Example 3-13, Example 3-14, Comparative Example 3-4, and Comparative Example 3-6, which had the same skeleton structure but different constituent ranges of R₁ revealed that particularly excellent planarizing property was exhibited in Examples 3-5 and 3-6, in which the proportion of "b" was 0.4≤b≤0.6. This is presumably because the balance between the organic groups contributing to flowability and the hydroxyl groups contributing to adhesiveness and heat resistance was optimum, so that films excellent in thermal flowability and thermal-contraction resistance were formed. In Examples 3-11 and 3-12 using the crosslinking agent, dense films excellent in heat resistance were formed, and thus more excellent planarizing property was exhibited than the compositions containing the resin singly.

### [Pattern Etching Test]

The resist underlayer film materials (UL-1 to -15 and Comparative UL-1 to -7) were each applied onto a SiO₂ wafer substrate having an HMDS-treated trench pattern (trench width: 10 µm, trench depth: 0.50 µm) and heated using a hot plate at 400°C for 60 seconds to form a resist underlayer film having a film thickness of 600 nm. This resist underlayer film was coated with a resist middle layer film material (SOG-1) and baked at 220°C for 60 seconds to form a resist middle layer film (SOG-1 film) having a film thickness of 35 nm. Then, a resist upper layer film material (SL resist for ArF) was applied and baked at 105°C for 60 seconds to form a resist upper layer film having a film thickness of 100 nm. The resist upper layer film was coated with a liquid immersion top coat material (TC-1) and baked at 90°C for 60 seconds to form a top coat having a film thickness of 50 nm.

The resist upper layer film material (SL resist for ArF) was prepared by: dissolving a polymer (RP1), an acid generator (PAG1), and a basic compound (Amine1) into an organic solvent containing 0.1 mass% FC-430 (manufactured by Sumitomo 3M Ltd.) according to proportions of Table 11; and filtering the solution through a 0.1-µm filter made of a fluorinated resin.

**[Table 11]**

| | Polymer (parts by mass) | Acid generator (parts by mass) | Basic compound (parts by mass) | Organic solvent (parts by mass) |
|---|---|---|---|---|
| SL resist for ArF | RP1 (100) | PAG1 (6.6) | Amine1 (0.8) | PGMEA (2500) |

The structural formulae of the polymer (RP1), acid generator (PAG1), and basic compound (Amine1) used are shown below.

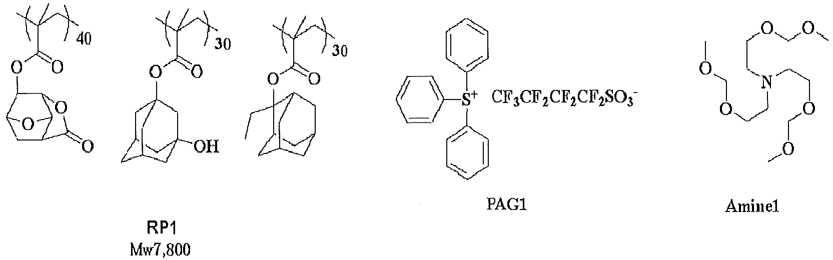

The liquid immersion top coat material (TC-1) was prepared by: dissolving a top coat polymer (PP1) into organic solvents according to proportions of Table 12; and filtering the solution through a 0.1-µm filter made of a fluorinated resin.

**[Table 12]**

| | Top coat polymer (parts by mass) | Organic solvent (parts by mass) |
|---|---|---|
| TC-1 | PP1 (100) | diisoamyl ether (2700) 2-methyl-1-butanol (270) |

The structural formula of the top coat polymer (PP1) used is shown below.

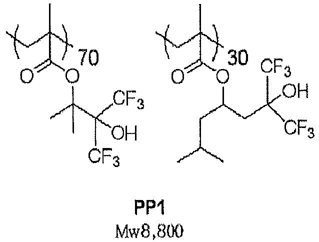

The resist middle layer film material (SOG-1) was prepared by: dissolving a polymer represented by ArF silicon-containing middle layer film polymer (SiP1) and a thermal crosslinking catalyst (CAT1) into an organic solvent containing 0.1 mass% FC-4430 (manufactured by Sumitomo 3M Ltd.) according to proportions shown in Table 13; and filtering the solution through a filter having a pore size of 0.1 µm made of a fluorinated resin to thus prepare the resist middle layer film material (SOG-1).

**[Table 13]**

| | Polymer (parts by mass) | Thermal crosslinking catalyst (parts by mass) | organic solvent (parts by mass) |
|---|---|---|---|
| SOG-1 | SiP1 (100) | CAT1 (1) | propylene glycol monoethyl ether (4000) |

The structural formulae of the ArF silicon-containing middle layer film polymer (SiP1) and thermal crosslinking catalyst (CAT1) used are shown below.

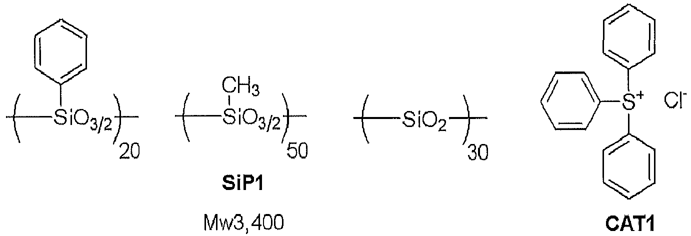

Next, the resulting substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked (PEB) at 100°C for 60 seconds, and developed with a 2.38 mass% tetramethylammonium hydroxide (TMAH) aqueous solution for 30 seconds. Thus, a 55 nm 1:1 positive line-and-space pattern was obtained.

Next, using an etching apparatus Telius manufactured by Tokyo Electron Limited, the SOG-1 film was processed by dry etching while the resist upper layer film pattern was being used as an etching mask; the resist underlayer film was processed while the SOG-1 film pattern was being used as an etching mask; and the SiO₂ film was processed while the resist underlayer film pattern was being used as an etching mask. The etching conditions were as follows.

Conditions for transferring the resist upper layer film pattern to the SOG-1 film.

| | |
|---|---|
| Chamber pressure: | 10.0 Pa |
| RF power: | 1,500 W |
| CF₄ gas flow rate: | 15 sccm |
| O₂ gas flow rate: | 75 sccm |
| Time: | 15 sec |

Conditions for transferring the SOG-1 film pattern to the resist underlayer film.

| | |
|---|---|
| Chamber pressure: | 2.0 Pa |
| RF power: | 500 W |
| Ar gas flow rate: | 75 sccm |
| O₂ gas flow rate: | 45 sccm |
| Time: | 240 sec |

Conditions for transferring the resist underlayer film pattern to the SiO₂ film.

| | |
|---|---|
| Chamber pressure: | 2.0 Pa |
| RF power: | 2,200 W |
| C₅F₁₂ gas flow rate: | 20 sccm |
| C₂F₆ gas flow rate: | 10 sccm |
| Ar gas flow rate: | 300 sccm |
| O₂ gas flow rate: | 60 sccm |
| Time: | 180 sec |

The resist underlayer film materials (UL-1 to -15 and Comparative UL-1 to -7) were each applied onto a SiO₂ wafer substrate having an HMDS-treated trench pattern (trench width: 10 µm, trench depth: 0.50 µm) to form a coating film by the same method as in Pattern Etching Test, except for baking at 550°C under a nitrogen stream with an oxygen concentration controlled to 0.2% or less. After the patterning and dry etching, the resulting pattern profile was observed.

Each pattern cross section was observed with an electron microscope (S-4700) manufactured by Hitachi, Ltd. Table 14 shows the results.

**[Table 14]**

| | Composition | Pattern transfer | |
|---|---|---|---|
| | | 400°C baking | 550°C baking |
| Example 4-1 | UL-1 | vertical profile | vertical profile |
| Example 4-2 | UL-2 | vertical profile | vertical profile |
| Example 4-3 | UL-3 | vertical profile | vertical profile |
| Example 4-4 | UL-4 | vertical profile | vertical profile |
| Example 4-5 | UL-5 | vertical profile | vertical profile |
| Example 4-6 | UL-6 | vertical profile | vertical profile |
| Example 4-7 | UL-7 | vertical profile | vertical profile |
| Example 4-8 | UL-8 | vertical profile | vertical profile |
| Example 4-9 | UL-9 | vertical profile | vertical profile |
| Example 4-10 | UL-10 | vertical profile | vertical profile |
| Example 4-11 | UL-11 | vertical profile | vertical profile |
| Example 4-12 | UL-12 | vertical profile | vertical profile |
| Example 4-13 | UL-13 | vertical profile | vertical profile |
| Example 4-14 | UL-14 | vertical profile | vertical profile |
| Example 4-15 | UL-15 | vertical profile | vertical profile |
| Comparative Example 4-1 | Comparative UL-1 | pattern collapsed | pattern collapsed |
| Comparative Example 4-2 | Comparative UL-2 | pattern collapsed | pattern collapsed |
| Comparative Example 4-3 | Comparative UL-3 | pattern collapsed | pattern collapsed |
| Comparative Example 4-4 | Comparative UL-4 | pattern collapsed | pattern collapsed |
| Comparative Example 4-5 | Comparative UL-5 | pattern collapsed | pattern collapsed |
| Comparative Example 4-6 | Comparative UL-6 | pattern collapsed | pattern collapsed |
| Comparative Example 4-7 | Comparative UL-7 | pattern collapsed | pattern collapsed |

It was verified as shown in Table 14 that in all of Examples 4-1 to 4-15 using the inventive resist underlayer film materials (UL-1 to -15), the resist upper layer film patterns were favorably transferred to the final substrates, and the inventive resist underlayer film materials are suitably used in fine processing by the multilayer resist method. In contrast, in Comparative Examples 4-1 to 4-7, which had been verified to have insufficient performances in Heat Resistance Evaluation, Filling Property Evaluation, and Planarizing Property Evaluation after each temperature baking at 400°C and 550°C, the patterns collapsed during the pattern processing, and favorable patterns were not obtained in the end.

From the above, it was revealed that the inventive resist underlayer film materials have all of favorable dry etching resistance, and high filling property, planarizing property, and adhesive force to a substrate, and further have heat resistance to 500°C or higher; thus, the inventive resist underlayer film materials are quite useful as resist underlayer film materials used in multilayer resist methods. Moreover, the inventive patterning processes using the materials can form fine patterns with high precision even when the body to be processed is a stepped substrate.

It should be noted that the present invention is not limited to the above-described embodiments. The embodiments are just examples, and any embodiments that substantially have the same feature and demonstrate the same functions and effects as those in the technical concept disclosed in claims of the present invention are included in the technical scope of the present invention.

## Claims

1. A resist underlayer film material used in a multilayer resist method, comprising:
(A) a resin having a compound shown in the following general formula (1A); and
(B) an organic solvent,
wherein a ratio Mw/Mn of a weight-average molecular weight Mw and a number-average molecular weight Mn of the compound shown in the general formula (1A) in terms of polystyrene by a gel permeation chromatography method is 1.00≤Mw/Mn≤1.25,
each X in the general formula (1A) represents a group shown by the following general formula (1B),
R₁ in the general formula (1B) represents any of a hydrogen atom, an organic group having 1 to 10 carbon atoms, and a structure shown in the following general formula (1C), and
the component (A) as a whole satisfies relations of a+b=1 and 0.2≤b≤0.8, where "a" represents a proportion of the hydrogen atom, and "b" represents a proportion of the organic group having 1 to 10 carbon atoms or structure shown by the general formula (1C) among the structures constituting R₁, 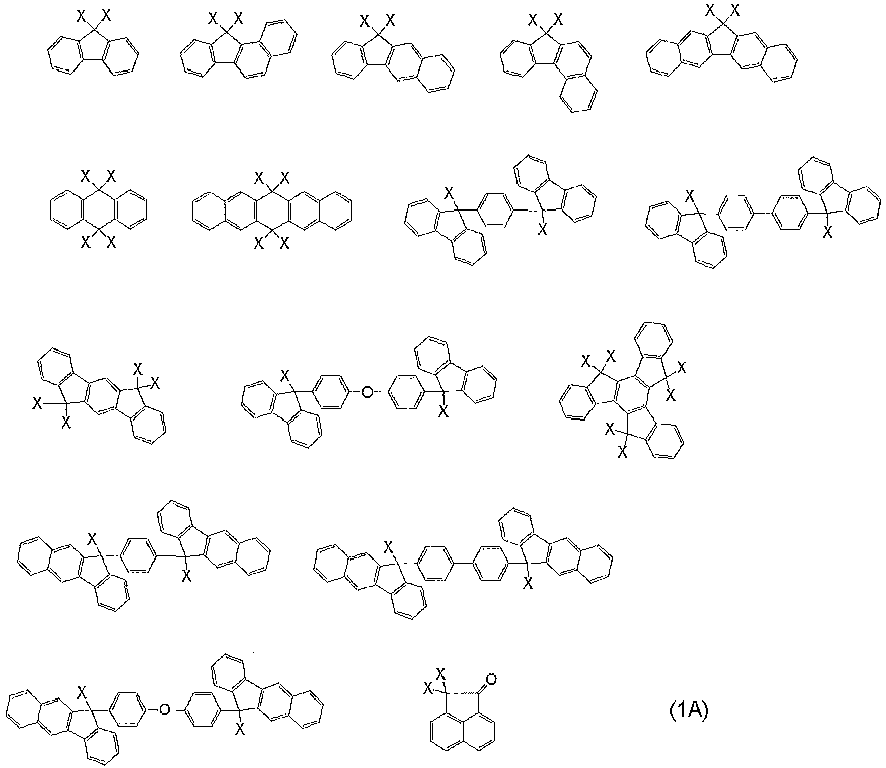 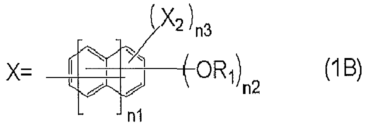 wherein n₁ represents 0 or 1; n₂ represents 1 or 2; R₁ represents any of a hydrogen atom, an organic group having 1 to 10 carbon atoms, and a structure shown in the following general formula (1C); the component (A) as a whole satisfies the relations of a+b=1 and 0.2≤b≤0.8, where "a" represents the proportion of the hydrogen atom, and "b" represents the proportion of the organic group having 1 to 10 carbon atoms or structure shown by the general formula (1C) among the structures constituting R₁; X₂ represents a group shown by the following general formula (1D); and n₃ represents 0, 1, or 2, 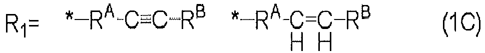 wherein * represents an attachment point to the oxygen atom, R^{A} represents a divalent organic group having 1 to 10 carbon atoms, and R^{B} represents a hydrogen atom or a monovalent organic group having 1 to 10 carbon atoms, 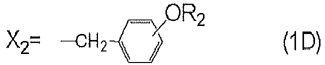 wherein R₂ represents a hydrogen atom or a saturated or unsaturated hydrocarbon group having 1 to 10 carbon atoms, and a hydrogen atom on the benzene ring in the general formula (1D) is optionally substituted with a methyl group or a methoxy group.

2. The resist underlayer film material according to claim 1, wherein a constituent component of R₁ in the general formula (1B) comprises a hydrogen atom and any in the following general formula (IF), 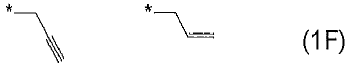 wherein * represents the attachment point to the oxygen atom.

3. The resist underlayer film material according to claim 1 or 2, wherein the compound shown in the general formula (1A) has a weight-average molecular weight of 2,500 or less.

4. The resist underlayer film material according to any one of claims 1 to 3, wherein the resist underlayer film material further comprises (C) a crosslinking agent.

5. The resist underlayer film material according to claim 4, wherein the crosslinking agent (C) is contained in an amount of 5 to 50 parts by mass based on 100 parts by mass of the resin (A).

6. The resist underlayer film material according to any one of claims 1 to 5, wherein the resist underlayer film material further comprises one or more of (D) a surfactant, (E) an acid generator, (F) a plasticizer, and (G) a pigment.

7. The resist underlayer film material according to any one of claims 1 to 6, wherein the organic solvent (B) comprises a high-boiling-point solvent.

8. The resist underlayer film material according to claim 7, wherein the high-boiling-point solvent comprises one or more organic solvents each having a boiling point of 180°C or higher.

9. A patterning process for forming a pattern in a substrate to be processed, comprising steps of:
(I-1) applying the resist underlayer film material according to any one of claims 1 to 8 onto the substrate to be processed, followed by heating to form a resist underlayer film;
(I-2) forming a resist upper layer film on the resist underlayer film by using a photoresist material;
(I-3) subjecting the resist upper layer film to pattern exposure and then development with a developer to form a pattern in the resist upper layer film;
(1-4) transferring the pattern to the resist underlayer film by dry etching while using the resist upper layer film having the formed pattern as a mask; and
(I-5) processing the substrate to be processed while using the resist underlayer film having the formed pattern as a mask to form the pattern in the substrate to be processed.

10. A patterning process for forming a pattern in a substrate to be processed, comprising steps of:
(II-1) applying the resist underlayer film material according to any one of claims 1 to 8 onto the substrate to be processed, followed by heating to form a resist underlayer film;
(II-2) forming a resist middle layer film on the resist underlayer film;
(II-3) forming a resist upper layer film on the resist middle layer film by using a photoresist material;
(II-4) subjecting the resist upper layer film to pattern exposure and then development with a developer to form a pattern in the resist upper layer film;
(II-5) transferring the pattern to the resist middle layer film by dry etching while using the resist upper layer film having the formed pattern as a mask;
(II-6) transferring the pattern to the resist underlayer film by dry etching while using the resist middle layer film having the transferred pattern as a mask; and
(II-7) processing the substrate to be processed while using the resist underlayer film having the formed pattern as a mask to form the pattern in the substrate to be processed.

11. A patterning process for forming a pattern in a substrate to be processed, comprising steps of:
(III-1) applying the resist underlayer film material according to any one of claims 1 to 8 onto the substrate to be processed, followed by heating to form a resist underlayer film;
(III-2) forming an inorganic hard mask middle layer film selected from a silicon oxide film, a silicon nitride film, and a silicon oxynitride film on the resist underlayer film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the resist underlayer film by dry etching while using the inorganic hard mask middle layer film having the transferred pattern as a mask; and
(III-8) processing the substrate to be processed while using the resist underlayer film having the formed pattern as a mask to form the pattern in the substrate to be processed.

12. The patterning process according to any one of claims 9 to 11, wherein the substrate to be processed has a structure or step with a height of 30 nm or more.

13. A method for forming a resist underlayer film that serves as an organic planarizing film employed in a semiconductor device manufacturing process, the method comprising:
spin-coating a substrate to be processed with the resist underlayer film material according to any one of claims 1 to 8; and
heating the substrate coated with the resist underlayer film material at a temperature of 100°C or higher and 600°C or lower for 10 to 600 seconds to form a cured film, preferably
wherein the substrate to be processed has a structure or step with a height of 30 nm or more.

14. A method for forming a resist underlayer film that serves as an organic planarizing film employed in a semiconductor device manufacturing process, the method comprising:
spin-coating a substrate to be processed with the resist underlayer film material according to any one of claims 1 to 8; and
heating the substrate coated with the resist underlayer film material under an atmosphere with an oxygen concentration of 1% or more and 21% or less to form a cured film, preferably
wherein the substrate to be processed has a structure or step with a height of 30 nm or more.

15. A method for forming a resist underlayer film that serves as an organic planarizing film employed in a semiconductor device manufacturing process, the method comprising:
spin-coating a substrate to be processed with the resist underlayer film material according to any one of claims 1 to 8; and
heating the substrate coated with the resist underlayer film material under an atmosphere with an oxygen concentration of less than 1% to form a cured film, preferably
wherein the substrate to be processed has a structure or step with a height of 30 nm or more.
